(19) **Europäisches Patentamt / European Patent Office / Office européen des brevets**

(11) **EP 3 654 556 A1**

(12) **EUROPEAN PATENT APPLICATION**
published in accordance with Art. 153(4) EPC

(43) Date of publication:
**20.05.2020 Bulletin 2020/21**

(21) Application number: **18831697.0**

(22) Date of filing: **09.07.2018**

(51) Int Cl.:
**H04L 1/00** (2006.01)

(86) International application number:
**PCT/CN2018/095051**

(87) International publication number:
**WO 2019/011219 (17.01.2019 Gazette 2019/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.07.2017 CN 201710561850**
**18.10.2017 CN 201710973473**

(71) Applicant: **Shanghai Jiao Tong University**
**Shanghai 200240 (CN)**

(72) Inventors:
• **XU, Yiling**
**Shanghai 200240 (CN)**

• **ZHANG, Wenjun**
**Shanghai 200240 (CN)**
• **LIU, Ning**
**Shanghai 200240 (CN)**
• **GUAN, Yunfeng**
**Shanghai 200240 (CN)**
• **WANG, Yanfeng**
**Shanghai 200240 (CN)**
• **SUN, Jun**
**Shanghai 200240 (CN)**
• **JIANG, Zhiqian**
**Shanghai 200240 (CN)**
• **CHEN, Hao**
**Shanghai 200240 (CN)**

(74) Representative: **Potter Clarkson**
**The Belgrave Centre**
**Talbot Street**
**Nottingham NG1 5GG (GB)**

(54) **MEDIA CONTENT-BASED ADAPTIVE METHOD, DEVICE AND SYSTEM FOR FEC CODING AND DECODING OF SYSTEMATIC CODE, AND MEDIUM**

(57) The present invention provides a method, device, system and medium for adaptive system code FEC encoding and decoding based on media content. The method comprises: according to importance of media content, dividing a source data into N types of source data packets according to a priority; according to the N types of the source data packets and the priorities thereof, generating N types of intermediate codes; according to the N types of the intermediate codes, setting recovery data of the N types of the source data according to a channel condition, generating encoded symbols of N types of system codes; receiving the encoded symbols, sorting and arranging the encoded symbols according to a decoding requirement; according to the number of received encoded symbols, decoding to obtain an intermediate codeword depending on conditions, and recovering a corresponding source data packet according to the intermediate codeword. The present invention maximizes quality of the media content, reducing data redundancy caused by FEC; does not need to split source data stream, reducing complexity of FEC encoding at a sending end and improving efficiency of FEC encoding; may dynamically adjust coding scheme according to change of current network state, having stronger adaptability.

FIG.5

## Description

This application claims priority benefit of the patent application CN201710973473.3, filed on October 18, 2017 and titled as "Method, Device and System for Adaptive System Code FEC Based on Media Content".

This application claims priority benefit of the patent application CN201710561850.2, filed on July 11, 2017 and titled as "FEC Encoding and Decoding Method of Adaptive System Code Based on Media Content".

## Technical Field

The present invention relates to the technical field of multimedia transmission, and in particular, to a method, device, system and medium for adaptive system code forward error correction (FEC) encoding and decoding based on media content.

## Background

In a heterogeneous network media service system, content is distributed to terminals through Internet protocols or broadcast protocols, wherein media data are sent by IP / TCP or UDP messages in the internet, and contents are sent through MPEG2-TS by broadcasts. UDP messages may be lost after passing through a plurality of network devices, and broadcast TS streams may have bit errors due to the influence of the transmission environment, which may cause screen damage or sound pause on the terminal side.

Forward Error Correction (FEC) technology is a coding technology widely used in communication systems. By performing error correction coding on media data and adding redundant information to send together with the media data at the server side, the terminal side performs reverse FEC decoding to recover the lost messages. Taking a typical block code as an example, the basic principle is: at a sending end, by encoding k bits of information as a block, and adding (n-k) bits of redundancy check information, a codeword with a length of n bits is formed. After the codeword reaches a receiving end through a channel, if an error is within an error-correctable range, the error bit may be checked and corrected by decoding, thereby resisting the interference caused by the channel, effectively reducing the bit error rate of the system, and improving the reliability of the communication system. However, FEC processing reduces bit error rate of system at cost of redundancy overhead. Excessive FEC encoding may also put pressure on system real-time and network status.

Unequal Error Protection (UEP) is a type of joint source channel coding. The core idea is that according to the importance of the data of each part of the code stream, different channel protection mechanisms are used for each part of the data, that is, provide focused protection for important code stream. Although UEP reduces the anti-noise performance of non-important code streams, it is beneficial to the improvement of overall error resistance of the system.

As a forward error correction coding technology, digital fountain code does not need feedback and automatic retransmission mechanism in transmission process, avoiding signal round-trip delay and feedback explosion problems in broadcasting applications. The basic idea of a digital fountain is: the sending end divides an original data into k data symbols, encodes the data symbols, and outputs an encoded symbol code stream of any length. The receiving end only needs to correctly receive n (n is slightly larger than k) encoded symbols to recover all k data symbols with a high probability. The digital fountain code itself has UEP performance, which can protect data of different importance.

Summary

In view of the defects in the prior art, the object of the present invention is to provide a method, device, system and medium for adaptive system code FEC encoding and decoding based on media content.

A method for adaptive system code FEC encoding and decoding based on media content according to the present invention, comprising:

according to importance of media content, dividing a source data into N types of source data packets according to priorities; the N is an integer greater than 1;
according to the source data and priorities of the N types of the source data packets, generating N types of intermediate codes;
according to the N types of the intermediate codes, setting recovery data of the N types of the source data according to a channel condition, generating N types of encoded symbols;
receiving the encoded symbols, sorting and arranging the coding symbols according to a decoding requirement, decoding the encoded symbols;
according to a condition of received encoded symbols, decoding to obtain preferentially the intermediate code with a high priority, and recovering a corresponding source data packet according to the intermediate code.

Preferably, the according to the source data and priorities of the N types of the source data packets, generating N types of intermediate codes, comprises:

constructing a coding matrix corresponding to the N types of the source data packets, recorded as $A_i$, $i = 1, 2, \ldots N$; wherein:

$$A_i = \begin{bmatrix} G\_p_i \\ G\_ENC_i \end{bmatrix} \quad i = 1, 2, \ldots N$$

in the formula: $A_i$ indicates a coding matrix corresponding to an *i-th* source data packet, $G\_p_i$ indicates a joint matrix composed of a LDPC matrix and an identity matrix and corresponding to the *i-th* source data packet, $G\_ENC_i$ indicates a LT coding matrix corresponding to the *i-th* source data packet;
constructing a coding matrix A of the source data according to the coding matrix corresponding to the N types of the source data packets, the coding matrix of the source data is as follows:

$$A = \begin{bmatrix} G\_p_1 & 0 & \ldots & 0 \\ G\_ENC_1 & 0 & \ldots & 0 \\ 0 & G\_p_i & \ldots & 0 \\ 0 & G\_ENC_i & \ldots & 0 \\ \ldots & \ldots & \ldots & \ldots \\ 0 & 0 & \ldots & G\_p_N \\ 0 & 0 & \ldots & G\_ENC_N \end{bmatrix}$$

$$A \begin{bmatrix} C_1 \\ C_2 \\ \ldots \\ C_i \\ \ldots \\ C_N \end{bmatrix} = \begin{bmatrix} 0 \\ D_1 \\ 0 \\ \ldots \\ D_i \\ \ldots \\ 0 \\ D_N \end{bmatrix}$$

then

$$\begin{bmatrix} C_1 \\ C_2 \\ \ldots \\ C_N \end{bmatrix} = \begin{bmatrix} A_1^{-1} & 0 & \ldots & 0 \\ 0 & A_2^{-1} & \ldots & 0 \\ \ldots & \ldots & \ldots & \ldots \\ \ldots & \ldots & \ldots & A_N^{-1} \end{bmatrix} \begin{bmatrix} 0 \\ D_1 \\ 0 \\ D_2 \\ \ldots \\ 0 \\ D_N \end{bmatrix}$$

in the formula: $C_1$, $C_2$ ..., $C_i$ ..., $C_N$ respectively correspond to the intermediate code of the N types of the source data packets, $D_1$, $D_2$, ..., $D_i$..., $D_N$ respectively correspond to data of the N types of the source data packets, superscript -1 is an inverse matrix operator.

Preferably, the according to the N types of the intermediate codes, setting recovery data of the N types of the source data according to a channel condition, comprises:

$$\begin{bmatrix} D_1 \\ D_2 \\ \dots \\ D_N \\ R_1 \\ R_2 \\ \dots \\ R_N \end{bmatrix} = \begin{bmatrix} G\_ENC_1 & 0 & \dots & 0 \\ 0 & G\_ENC_2 & \dots & 0 \\ \dots & \dots & \dots & \dots \\ 0 & 0 & \dots & G\_ENC_N \\ G\_ENC_{11} & 0 & \dots & 0 \\ G\_ENC_{12} & G\_ENC_{21} & \dots & 0 \\ \dots & \dots & \dots & \dots \\ G\_ENC_{1N} & G\_ENC_{2(N-1)} & \dots & G\_ENC_{N1} \end{bmatrix} \begin{bmatrix} C_1 \\ C_2 \\ \dots \\ C_N \end{bmatrix}$$

in the formula: $R_1, R_2 ..., R_i ..., R_N$ respectively correspond to the recovery data of the N types of the source data packets, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

Preferably, when value of the N is 2, corresponding intermediate codes can be generated for data of different importance as follows:

$$\begin{bmatrix} C_1 \\ C_2 \end{bmatrix} = \begin{bmatrix} A_1^{-1} & 0 \\ 0 & A_2^{-1} \end{bmatrix} \begin{bmatrix} 0 \\ D_1 \\ 0 \\ D_2 \end{bmatrix}$$

changing structure of the LT coding matrix to obtain $G\_ENC_{11}$, $G\_ENC_{12}$, $G\_ENC_{21}$, $G\_ENC_{12}$ and $G\_ENC_1$ having same generation manner; $G\_ENC_{21}$ and $G\_ENC_2$ having same generation manner; $G\_ENC_{11}$ indicating a LT coding matrix having same generation manner as $G\_ENC_1$; $G\_ENC_{21}$ indicating a LT coding matrix having same generation manner as $G\_ENC_2$; $G\_ENC_{12}$ indicating a LT coding matrix having same generation manner as $G\_ENC_1$;

the obtained recovery data $R_1$ is only related to data with a priority of 1, and the recovery data $R_2$ is related to data with priorities of 1 and 2, then obtaining:

$$\begin{bmatrix} D_1 \\ D_2 \\ R_1 \\ R_2 \end{bmatrix} = \begin{bmatrix} G\_ENC_1 & 0 \\ 0 & G\_ENC_2 \\ G\_ENC_{11} & 0 \\ G\_ENC_{12} & G\_ENC_{21} \end{bmatrix} \begin{bmatrix} C_1 \\ C_2 \end{bmatrix}.$$

Preferably, when value of the N is 2, the receiving the encoded symbols and decoding the encoded symbols, comprises:

in the first stage of decoding, obtaining an intermediate codeword according to a recovery matrix W and received source data packets; specifically:

$$W \begin{bmatrix} C_1 \\ C_2 \end{bmatrix} = \begin{bmatrix} 0 \\ REV\_D_1 \\ 0 \\ REV\_D_2 \\ REV\_R_1 \\ REV\_R_2 \end{bmatrix}$$

$$W = \begin{bmatrix} G\_p_1 & 0 \\ REV\_G\_ENC_1 & 0 \\ 0 & G\_p_2 \\ 0 & REV\_G\_ENC_2 \\ REV\_G\_ENC_{11} & 0 \\ REV\_G\_ENC_{12} & REV\_G\_ENC_{21} \end{bmatrix}$$

in the formula: $REV\_G\_ENC_1$ indicates the LT coding matrix with lines corresponding to lost packets removed from $G\_ENC_1$ according to packet loss condition of received encoded symbols; $REV\_G\_ENC_{11}$ indicates the LT coding matrix after with lines corresponding to lost packets removed from $G\_ENC_{11}$ according to packet loss condition of received encoded symbols; $REV\_G\_ENC_{12}$ indicates the LT coding matrix with lines corresponding to lost packets from $G\_ENC_{12}$ according to packet loss condition of received encoded symbols; $REV\_G\_ENC_2$ indicates the LT coding matrix with lines corresponding to lost packets from $G\_ENC_2$ according to packet loss condition of received encoded symbols; $REV\_G\_ENC_{21}$ indicates the LT coding matrix with lines corresponding to lost packets from $G\_ENC_{21}$ according to packet loss condition of received encoded symbols;

making $$REV\_A = \begin{bmatrix} G\_p_1 & 0 \\ REV\_G\_ENC_1 & 0 \\ REV\_G\_ENC_{11} & 0 \\ 0 & G\_p_2 \\ 0 & REV\_G\_ENC_2 \\ REV\_G\_ENC_{12} & REV\_G\_ENC_{21} \end{bmatrix}$$ ; and decoding according to a number of received source data packets with a corresponding priority and a total number of received data packets;
when a total number of received encoded symbols is less than a number of encoded symbols generated by the source data, and a number of rows is less than a number of columns in $REV\_A_1 = \begin{bmatrix} G\_p_1 \\ REV\_G\_ENC_1 \\ REV\_G\_ENC_{11} \end{bmatrix}$;

both $C_1$, $C_2$ are unable to be solved;
when the total number of received encoded symbols is less than the number of encoded symbols generated by the source data, and the number of rows is greater than or equal to the number of columns in

$REV\_A_1 = \begin{bmatrix} G\_p_1 \\ REV\_G\_ENC_1 \\ REV\_G\_ENC_{11} \end{bmatrix}$; if the number of rows is greater than or equal to the number of columns in

$REV\_A_1 = \begin{bmatrix} G\_p_1 \\ REV\_G\_ENC_1 \\ REV\_G\_ENC_{11} \end{bmatrix}$, then $REV\_A_1$ is invertible, a corresponding inverse matrix is recorded as

$REV\_A_1{}^{-1}$; then it can be obtained: $[C_1] = REV\_A^{-1} \begin{bmatrix} 0 \\ REV\_D_1 \\ REV\_R_1 \end{bmatrix}$ wherein: $C_2$ has no solution;

in the formula: $REV\_D_1$ indicates received source data with a priority of 1, $REV\_R_1$ indicates received recovery data of the source data with the priority of 1;

when the total number of received encoded symbols is greater than or equal to the number of encoded symbols generated by the source data, and the number of rows is greater than or equal to the number of columns in $REV\_A_1$

$$= \begin{bmatrix} G\_p_1 \\ REV\_G\_ENC_1 \\ REV\_G\_ENC_{11} \end{bmatrix};$$ if the number of rows is greater than or equal to the number of columns in

$$REV\_A_1 = \begin{bmatrix} G\_p_1 \\ REV\_G\_ENC_1 \\ REV\_G\_ENC_{11} \end{bmatrix},$$ then $REV\_A_1$ is invertible, a corresponding inverse matrix is recorded as

$REV\_A_1^{-1}$; if a number of rows is greater than or equal to a number of columns in

$$REV\_A_2 = \begin{bmatrix} G\_p_2 \\ REV\_G\_ENC_2 \\ REV\_G\_ENC_{21} \end{bmatrix},$$ then $REV\_A_2$ is invertible, a corresponding inverse matrix is recorded as

$REV\_A_2^{-1}$; if both $REV\_A_1$ and $REV\_A_2$ are invertible, then $REV\_A$ is invertible, a corresponding inverse matrix is recorded as $REV\_A^{-1}$, recording $B_{1\_1} = \begin{bmatrix} 0 \\ 0 \\ REV\_G\_ENC_{12} \end{bmatrix},$ then

$$REV\_A^{-1} = \begin{bmatrix} REV\_A_1^{-1} & 0 \\ REV\_A_2^{-1}B_{1\_1}REV\_A_1^{-1} & REV\_A_2^{-1} \end{bmatrix};$$ obtaining:

$$\begin{bmatrix} C_1 \\ C_2 \end{bmatrix} = REV\_A^{-1}\begin{bmatrix} 0 \\ REV\_D_1 \\ REV\_R_1 \\ 0 \\ REV\_D_2 \\ REV\_R_2 \end{bmatrix} = \begin{bmatrix} REV\_A_1^{-1} & 0 \\ REV\_A_2^{-1}B_{1\_1}REV\_A_1^{-1} & REV\_A_2^{-1} \end{bmatrix}\begin{bmatrix} 0 \\ REV\_D_1 \\ REV\_R_1 \\ 0 \\ REV\_D_2 \\ REV\_R_2 \end{bmatrix};$$

if the number of rows is less than the number of columns in $REV\_A_2 = \begin{bmatrix} G\_p_2 \\ REV\_G\_ENC_2 \\ REV\_G\_ENC_{21} \end{bmatrix},$ then $REV\_A_2$

does not have an inverse matrix, only $\begin{bmatrix} C_1 \end{bmatrix} = REV\_A^{-1}\begin{bmatrix} 0 \\ REV\_D_1 \\ REV\_R_1 \end{bmatrix}$ is obtained;

in the formula: $REV\_D_2$ indicates received source data with a priority of 2, $REV\_R_2$ indicates received recovery data of the source data with priorities of 1 and 2;
when the total number of received encoded symbols is greater than or equal to the number of encoded symbols generated by the source data, and the number of rows is less than the number of columns in

$$REV\_A_1 = \begin{bmatrix} G\_p_1 \\ REV\_G\_ENC_1 \\ REV\_G\_ENC_{11} \end{bmatrix},$$ the number of rows is greater than or equal to the number of columns in

$$REV\_A_2 = \begin{bmatrix} G\_p_2 \\ REV\_G\_ENC_2 \\ REV\_G\_ENC_{21} \end{bmatrix};$$

using Gaussian elimination method to directly solve matrix $REV\_A$, that is, solving following linear equations:

$$\begin{bmatrix} G\_p_1 & 0 \\ REV\_G\_ENC_1 & 0 \\ REV\_G\_ENC_{11} & 0 \\ 0 & G\_p_2 \\ 0 & REV\_G\_ENC_2 \\ REV\_G\_ENC_{12} & REV\_G\_ENC_{21} \end{bmatrix} \begin{bmatrix} C_1 \\ C_2 \end{bmatrix} = \begin{bmatrix} 0 \\ REV\_D_1 \\ REV\_R_1 \\ 0 \\ REV\_D_2 \\ REV\_R_2 \end{bmatrix}$$

obtaining $C_1$, $C_2$.

Preferably, due to a loss of a part of the data, a recovery matrix needs to be generated according to received encoded symbols, which is equivalent to erasing matrix rows corresponding to lost encoded symbols to form the corresponding recovery matrix, recorded as $REV\_G\_ENC$; according to different numbers of received data packets, intermediate codewords are generated for different conditions; specifically, following steps are comprised:

step A1: assuming that data packets with $l$ types of priorities are received; then obtaining a following recovery matrix equation:

$$\begin{bmatrix} G\_p_1 & 0 & \ldots & 0 \\ REV\_G\_ENC_1 & 0 & \ldots & 0 \\ 0 & G\_p_2 & \ldots & 0 \\ 0 & REV\_G\_ENC_2 & \ldots & 0 \\ \ldots & \ldots & \ldots & \ldots \\ 0 & 0 & \ldots & G\_p_l \\ 0 & 0 & \ldots & REV\_G\_ENC_l \\ REV\_G\_ENC_{11} & 0 & \ldots & 0 \\ REV\_G\_ENC_{12} & REV\_G\_ENC_{21} & \ldots & 0 \\ \ldots & \ldots & \ldots & \ldots \\ REV\_G\_ENC_{1l} & REV\_G\_ENC_{2(l-1)} & \ldots & REV\_G\_ENC_{l1} \end{bmatrix} \begin{bmatrix} C_1 \\ C_2 \\ \ldots \\ C_l \end{bmatrix} = \begin{bmatrix} 0 \\ REV\_D_1 \\ 0 \\ REV\_D_2 \\ \ldots \\ 0 \\ REV\_D_l \\ REV\_R_1 \\ REV\_R_2 \\ \ldots \\ REV\_R_l \end{bmatrix}$$

performing an elementary row transformation on the recovery matrix equation, obtaining:

$$\begin{bmatrix} G\_p_1 & 0 & \ldots & 0 \\ REV\_G\_ENC_1 & 0 & \ldots & 0 \\ REV\_G\_ENC_{11} & 0 & \ldots & 0 \\ 0 & G\_p_2 & \ldots & 0 \\ 0 & REV\_G\_ENC_2 \ldots & \ldots & \ldots \\ REV\_G\_ENC_{12} & REV\_G\_ENC_{21} & \ldots & 0 \\ \ldots & \ldots & \ldots & \ldots \\ 0 & 0 & \ldots & G\_p_l \\ 0 & 0 & \ldots & REV\_G\_ENC_l \\ REV\_G\_ENC_{1l} & REV\_G\_ENC_{2(l-1)} & \ldots & REV\_G\_ENC_{l1} \end{bmatrix} \begin{bmatrix} C_1 \\ C_2 \\ \ldots \\ C_l \end{bmatrix} = \begin{bmatrix} 0 \\ REV\_D_1 \\ REV\_R_1 \\ 0 \\ REV\_D_2 \\ REV\_R_2 \\ \ldots \\ 0 \\ REV\_D_l \\ REV\_R_l \end{bmatrix}$$

in the formula: $REV\_G\_ENC_1$ indicates the LT coding matrix with lines corresponding to lost packets removed from $G\_ENC_1$ according to packet loss condition of the received encoded symbols; $REV\_G\_ENC_{11}$ indicates the LT coding matrix with lines corresponding to lost packets removed from $G\_ENC_{11}$ according to packet loss condition of the received encoded symbols; $REV\_G\_ENC_{12}$ indicates the LT coding matrix with lines corresponding to lost packets removed from $G\_ENC_{12}$ according to packet loss condition of the received encoded symbols; $REV\_G\_ENC_2$

indicates the LT coding matrix with lines corresponding to lost packets removed from $G\_ENC_2$ according to packet loss condition of the received encoded symbols; $REV\_G\_ENC_{21}$ indicates the LT coding matrix with lines corresponding to lost packets removed from $G\_ENC_{21}$ according to packet loss condition of the received encoded symbols; $REV\_D_1$ indicates received source data with a priority of 1, $REV\_R_1$ indicates received recovery data of the source data with the priority of 1; $REV\_D_2$ indicates a received source data with a priority of 2, $REV\_R_2$ indicates received recovery data of the data with priorities of 1 and 2; $REV\_G\_ENC_{1l}$ indicates the LT coding matrix with lines corresponding to lost packets removed from $G\_EN\_C_{1l}$ according to packet loss condition of the received encoded symbols, $REV\_D_l$ indicates received source data with a priority of $l$, $REV\_R_l$ indicates received recovery data of the source data with priorities of 1 to $l$, $C_l$ indicates a generated intermediate code of type $l$;

step A2:

making

$$REV\_A =$$

$$\begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_l \\ 0 & 0 & ... & REV\_G\_ENC_l \\ REV\_G\_ENC_{1l} & REV\_G\_ENC_{2(l-1)} & ... & REV\_G\_ENC_{l1} \end{bmatrix}$$, making R($i$) be a number of encoded symbols of level i as received and extended, L(i) be a symbol length of each level at an encoding end, wherein: $1 \leq i \leq l$;
calculating a rank of a generated matrix of each level:

$$eachRank(i) = min(Len(R(i)), sum(L(1:i)));$$

in the formula: eachRank(i) indicates a rank of a sub-matrix corresponding to data with a priority of i, wherein a corresponding sub-matrix is $\begin{bmatrix} 0 & G\_p_2 \\ 0 & REV\_G\_ENC_2 \\ REV\_G\_ENC_{12} & REV\_G\_ENC_{21} \end{bmatrix}$ when i=2, Len(R(i)) indicates a length of the number of received encoded symbols with a priority of i, sum(L(1:i)) indicates a number of columns of a sub-matrix with a priority of i, min() indicates a minimum operation;
calculating a rank of an accumulated matrix:

$$cumRank(i) = min(cumRank(i-1) + eachRank(i), sum(L(1:i))),$$

in the formula: cumRank(i) indicates a sum of ranks of sub-matrices corresponding to a priority of 1 to a priority of i, cumRank(i - 1) indicates a sum of ranks of sub-matrices corresponding to a priority of 1 to a priority of i-1; wherein cumRank(1) = eachRank(1);
judging cumRank(i) >= $sum$(L(1:$i$)) in order: if it is true, cumFullRank(i) = 1; otherwise cumFullRank(i) = 0; cumFullRank(i) indicates a full rank of a matrix consisting of sub-matrices corresponding to a priority of 1 to a priority of i;

step A3: according to the number of received encoded symbol each level, respectively obtaining intermediate codes $C_1$, $C_2$, ... $C_l$ according to conditions, setting an initial value of $i$ to 1;

if cumFullRand(i) == 1 && cumFullRank(1:i) > 0 is satisfied, using RFC 6330 decoding method to solve $C_1 \sim C_i$, wherein: && indicates an AND operation, cumFullRank(1:i) indicates a full rank of the matrix consisting of sub-matrices of priorities from 1 to i; $C_1$ indicates an intermediate codeword corresponding to data with a priority of 1, $C_i$ indicates an intermediate codeword corresponding to data with a priority of $i$;

assuming

$$REV\_A_{\Delta i} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix},$$

obtaining:

$$REV\_A_{\Delta i}^{-1} = \begin{bmatrix} A_1^{-1} & 0 & 0 & 0 \\ X_{1\_2} & A_2^{-1} & 0 & 0 \\ ... & ... & ... & 0 \\ X_{1\_i} & X_{2\_(i-1)} & ... & A_i^{-1} \end{bmatrix},$$

wherein:

$X_{1\_2} = A_2^{-1} B_{1\_2} A_1^{-1}$, $X_{a\_b} = A_b^{-1} B_{a\_b} A_a^{-1} + \sum_{k=a+1}^{b-1} A_b^{-1} B_{k\_b} X_{a\_k}$,

in the formula: $REV\_A_{\Delta i}$ indicates a full rank matrix consisting of all sub-matrices until the priority reaches i, $B_{1\_2}$ indicates sub-matrix $\begin{bmatrix} 0 \\ 0 \\ REV\_G\_ENC_{12} \end{bmatrix}$, $X_{1\_2}$ indicates a sub-matrix after an inverse operation on sub-matrix $B_{1\_2}$, $X_{a\_b}$ indicates a sub-matrix obtained after an inverse operation of sub-matrix $B_{a\_b}$, $B_{a\_b}$ indicates sub-matrix 0 , the range of a is 1 ~ i, the range of b is 2 ~ i, $A_i^{-1}$ indicates an inverse matrix of sub-matrix $\begin{bmatrix} G\_p_i \\ REV\_G\_ENC_i \\ REV\_G\_ENC_{i1} \end{bmatrix}$;

making $C_{i\_temp} = REV\_A_i^{-1} \begin{bmatrix} 0 \\ REV\_D_i \\ REV\_R_i \end{bmatrix}$, wherein, $REV\_A_i = \begin{bmatrix} G\_p_i \\ REV\_G\_ENC_i \\ REV\_G\_ENC_{i1} \end{bmatrix}$; $REV\_A_i^{-1}$ is an inverse matrix of $REV\_A_i$, then obtaining:

$$C_1 = C_{1\_temp}$$

$$C_2 = C_{2\_temp} + X_{1\_2} \begin{bmatrix} 0 \\ REV\_D_1 \\ REV\_R_1 \end{bmatrix} = C_{2\_temp} + A_2^{-1} B_{1\_2} C_1$$

$$C_3 = C_{3\_temp} + X_{1\_3} \begin{bmatrix} 0 \\ REV\_D_1 \\ REV\_R_1 \end{bmatrix} + X_{2\_3} \begin{bmatrix} 0 \\ REV\_D_2 \\ REV\_R_2 \end{bmatrix} = C_{2\_temp} + A_3^{-1} B_{1\_3} C_1 + A_3^{-1} B_{2\_3} C_2$$

according to mathematical induction, obtaining:

$$C_i = C_{i\_temp} + \sum_{j=1}^{i-1} X_{j\_i} \begin{bmatrix} 0 \\ REV\_D_j \\ REV\_R_j \end{bmatrix} = C_{i\_temp} + \sum_{j=1}^{i-1} A_i^{-1} B_{j\_i} C_j$$

obtaining $C_1$, $C_2$ ... $C_i$ wherein, $C_{i+1}$ ... $C_l$ are unable to be solved;
if cumFullRand(i) == 1 is satisfied, and cumFullRank(1:i) > 0 is not satisfied, using Gaussian elimination method to solve $C_1 \sim C_i$
assuming

$$REV\_A_{\Delta i} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix},$$

solving following linear equations by Gaussian elimination method:

$$\begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix} \begin{bmatrix} C_1 \\ C_2 \\ ... \\ C_i \end{bmatrix} = \begin{bmatrix} 0 \\ REV\_D_1 \\ REV\_R_1 \\ 0 \\ REV\_D_2 \\ REV\_R_2 \\ ... \\ 0 \\ REV\_D_i \\ REV\_i \end{bmatrix}$$

obtaining $C_1$, $C_2$ ... $C_i$, wherein, $C_{i+1}$ ... $C_l$ are unable to be solved;
for any value of i, if cumFullRand(i) == 1 is not satisfied then a corresponding $C_i$ is unable to be solved; if cumFull-

Rank(1:i) > 0 is not satisfied either until i == 1, then $C_1, C_2... C_i$ are all unable to be solved, the decoding failed;
step A4: decrementing the value of i by 1, returning to perform step A3.

Preferably, the method further comprises:

parsing importance information of a header of each sub-packet in the source data packet;
according to the importance information, respectively mapping each sub-packet in the source data packet to a different priority;
rearranging the sub-packets according to the priorities of the sub-packets to get an intermediate data packet;
after converting the intermediate data packet into a plurality of symbols, and performing forward error correction (FEC) encoding on the intermediate data packet that is converted into the plurality of symbols, obtaining a recovery data packet comprising a plurality of symbols;
adding an index field and/or a priority indicating field to the recovery data packet, the index field is used to indicate a sequence of sub-packets in the recovery data packet and/or indicate a sequence of sub-packets, in the recovery data packet, at a priority corresponding to the priority indicating field; further adding an index field and/or a priority indicating field to the intermediate data packet, the index field is used to indicate a sequence of the sub-packets in the intermediate data packet and/or indicate a sequence of the sub-packets, in the intermediate data packet, at a priority corresponding to the priority indicating field;
adding corresponding instruction information to the recovery data packet and the intermediate data packet, or sending corresponding instruction information when sending the recovery data packet and the intermediate data packet, the instruction information is used to indicate the sub-packets of the recovery data packet at each priority, and a number or a proportion of the sub-packets belonging to a corresponding priority in the recovery data packet; the indication information is also used to indicate the sub-packets in the intermediate data packet at each priority, and a number or a proportion of the sub-packets belonging to a corresponding priority in the intermediate data packet;
sending the recovery data packet and the intermediate data packet comprising the instruction information to a terminal side, or sending the recovery data packet, the intermediate data packet, and corresponding instruction information to a terminal side.

Preferably, the parsing importance information of a header of each sub-packet in the source data packet, comprises:
reading a priority field in the header of each sub-packet, determining a priority of a corresponding sub-packet according to information in the priority field.

Preferably, the according to the importance information, respectively mapping each sub-packet in the source data packet to a different priority, comprises:

determining a number of priorities actually adopted by the source data packet, and a mapping relationship to the priority field at each priority;
according to the mapping relationship, mapping the sub-packet to a corresponding preset priority.

Preferably, the after converting the intermediate data packet into a plurality of symbols, and performing forward error correction (FEC) encoding on the intermediate data packet that is converted into the plurality of symbols, obtaining a recovery data packet comprising a plurality of symbols, comprises:

performing FEC encoding on the intermediate data packet, using an adaptive FEC encoding method of a RaptorQ system code, to obtain a following intermediate codeword:

$$\begin{bmatrix} C_1 \\ C_2 \\ ... \\ C_N \end{bmatrix} = \begin{bmatrix} A_1^{-1} & 0 & ... & 0 \\ 0 & A_2^{-1} & ... & 0 \\ ... & ... & ... & ... \\ ... & ... & ... & A_N^{-1} \end{bmatrix} \begin{bmatrix} 0 \\ D_1 \\ 0 \\ D_2 \\ ... \\ 0 \\ D_N \end{bmatrix}$$

in the formula: $A_i$ indicates a coding matrix corresponding to a source data packet of type $i$, $C_1, C_2, ..., C_i ..., C_N$

respectively correspond to an intermediate code of the N types of the source data packets, $D_1$, $D_2$, ..., $D_i$ ..., $D_N$ respectively correspond to data of the N types of the source data packets, superscript -1 is an inverse matrix operator; according to the intermediate codeword, obtaining the recovery data packet, and adding a FEC payload ID to the recovery data packet, wherein, the recovery data in the recovery data packet is as follows:

$$
\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\,(N-1)}} & ... & G_{ENC_{N1}} \end{bmatrix} \begin{bmatrix} C_1 \\ C_2 \\ ... \\ C_N \end{bmatrix}
$$

in the formula: $R_1$, $R_2$, ..., $R_i$ ..., $R_N$ respectively correspond to recovery data of 1~N source data packets, $G\_ENC_i$ indicates a LT coding matrix corresponding to an *i-th* source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

A method for adaptive system code FEC encoding and decoding based on media content according to the present invention, comprising:

receiving a recovery data packet and an intermediate data packet sent by a server, or receiving a recovery data packet, an intermediate data and corresponding instruction information;
parsing out an index field comprised in the recovery data packet and the intermediate data packet, and generating a coding matrix according to the index field, wherein, the index field is used to indicate a sequence of sub-packets in the recovery data packet, and indicate sub-packets in the intermediate data packet at each priority; or
directly obtaining index information via priority indicating fields of the recovery data packet and the intermediate data packet, and generating a coding matrix according to the index information, wherein, the index information is used to indicate a sequence of sub-packets in the recovery data packet and indicate sub-packets in the intermediate data packet at each priority;
performing forward error correction (FEC) decoding on the coding matrix to recover the intermediate data packet;
parsing information in a header of the intermediate data packet, rearranging a sequence of the sub-packets in the intermediate data packet, and recovering a source data packet.

Preferably, the parsing out an index field comprised in the recovery data packet and the intermediate data packet, comprises:
obtaining an index field of a corresponding row of a coding matrix corresponding to the source data by a following formula:

$$index = FEC\ payload\ ID -$$

$$number\ of\ packets\ of\ all\ priorities\ before\ this\ packet$$

in the formula: the index indicates a corresponding row index of the coding matrix corresponding to the source data, the FEC payload ID indicates index information of the header of the data packet, the number of packets of all priorities before this packet indicates a total number of data packets of all priorities before the data packet.
Preferably, the performing forward error correction (FEC) decoding on the coding matrix to recover the intermediate data packet, comprises:

performing an elementary row transformation on the coding matrix, and sorting symbols in a received corresponding recovery data packet, determining belonged priorities and transformed positions of the symbols according to a value of the index information FEC_payload_ID of the header of the recovery data packet and a number of the symbols with a corresponding priority; or

according to a priority field in the header of the recovery packet and the index information with a priority corresponding to the priority field, directly determining belonged priorities and transformed positions of the symbols;

adjusting a sequence of the symbols in the recovery data packet, and obtaining recovered intermediate data packet comprising a plurality of symbols after a decoding by a Gaussian elimination decoder and a RFC6330 decoder;

converting the intermediate data packet comprising the plurality of symbols into the intermediate packet.

A device for adaptive system code FEC encoding and decoding based on media content according to the present invention, comprising:

a parsing module, configured to parse importance information of a header of each sub-packet in a source data packet;

a mapping module, configured to respectively map each sub-packet in the source data packet to a different preset priority according to the importance information;

a sorting module, configured to rearrange the sub-packets according to the preset priority to obtain an intermediate data packet;

an encoding module, configured to convert the intermediate data packet into a plurality of symbols, and obtain a recovery data packet, comprising the plurality of symbols, after performing forward error correction (FEC) encoding on the intermediate data packet that is converted to a plurality of symbols;

an indexing module, configured to add an index field and/or a priority indicating field to the recovery data packet, the index field is used to indicate a sequence of sub-packets in the recovery data packet and/or indicate a sequence of sub-packets in the recovery data packet with a priority corresponding to the priority indicating field; further add an index field and/or a priority indicating field to the intermediate data packet, the index field is used to indicate a sequence of sub-packets in the intermediate data packet and/or indicate a sequence of sub-packets in the intermediate data packet with a priority corresponding to the priority indicating field;

an instruction information generating module, configured to add corresponding instruction information to the recovery data packet and the intermediate data packet, or send corresponding instruction information when sending the recovery data packet and the intermediate data packet; wherein, the instruction information is used to indicate the sub-packets of the recovery data packet at each priority, and a number or a proportion of the sub-packets belonging to a corresponding priority in the recovery data packet; the instruction information is further used to indicate the sub-packets of the intermediate data packet at each priority, and a number or a proportion of the sub-packets belonging to a corresponding priority in the intermediate data packet;

a sending module, configured to send the recovery data packet, the intermediate data packet, and corresponding signaling information to a terminal side, or send the recovery data packet, the intermediate data packet and corresponding instruction information to a terminal side.

Preferably, the encoding module is specifically configured to:

perform FEC encoding on the intermediate data packet, using an adaptive FEC encoding method of a RaptorQ system code, to obtain a following intermediate codeword:

$$
\begin{bmatrix} C_1 \\ C_2 \\ \dots \\ C_N \end{bmatrix} = \begin{bmatrix} A_1^{-1} & 0 & \dots & 0 \\ 0 & A_2^{-1} & \dots & 0 \\ \dots & \dots & \dots & \dots \\ \dots & \dots & \dots & A_N^{-1} \end{bmatrix} \begin{bmatrix} 0 \\ D_1 \\ 0 \\ D_2 \\ \dots \\ 0 \\ D_N \end{bmatrix}
$$

in the formula: $A_i$ indicates a coding matrix corresponding to a source data packet of type $i$, $C_1$, $C_2$, ..., $C_i$ ..., $C_N$ respectively correspond to an intermediate code of the N types of the source data packets, $D_1$, $D_2$, ..., $D_i$ ..., $D_N$ respectively correspond to data of the N types of the source data packets, superscript -1 is an inverse matrix operator; according to the intermediate codeword, obtain the recovery data packet, and adding a FEC payload ID to the recovery data packet, wherein, the recovery data in the recovery data packet is as follows:

$$\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\,(N-1)}} & ... & G_{ENC_{N1}} \end{bmatrix} \begin{bmatrix} C_1 \\ C_2 \\ ... \\ C_N \end{bmatrix}$$

in the formula: $R_1$, $R_2$, ..., $R_i$ ..., $R_N$ respectively correspond to recovery data of 1~N source data packets, $G\_ENC_i$ indicates a LT coding matrix corresponding to an *i-th* source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

A device for adaptive system code FEC encoding and decoding based on media content according to the present invention, comprising:

a receiving module, configured to receive a recovery data packet and an intermediate data packet sent by a server, or receive a recovery data packet, an intermediate data and corresponding instruction information;

a coding matrix generating module, configured to parse out an index field comprised in the recovery data packet and the intermediate data packet, and generate a coding matrix according to the index field, wherein, the index field is used to indicate a sequence of sub-packets in the recovery data packet and indicate sub-packet of the intermediate data packet at each priority; or

directly obtain index information via the priority indicating field of the recovery data packet and the intermediate data packet, and generate a coding matrix according to the index information, wherein, the index information is used to indicate a sequence of sub-packets in the recovery data packet and indicate sub-packet of the intermediate packet at each priority;

a decoding module, configured to perform forward error correction (FEC) decoding on the coding matrix to recover the intermediate data packet;

a recovering module, configured to parse information in the header of the intermediate data packet, rearrange a sequence of the sub-packets in the intermediate data packet, and recover the source data packet.

Preferably, the coding matrix generating module is specifically configured to:
obtain an index field of a corresponding row of a coding matrix corresponding to the source data by a following formula:

$$index = FEC\ payload\ ID -$$

$$number\ of\ packets\ of\ all\ priorities\ before\ this\ packet$$

in the formula: the index indicates a corresponding row index of the coding matrix corresponding to the source data, the FEC payload ID indicates index information of the header of the data packet, the number of packets of all priorities before this packet indicates a total number of data packets of all priorities before the data packet.

Preferably, the decoding module is specifically configured to:

perform an elementary row transformation on the coding matrix, and sort the symbols in a received corresponding recovery data packet, determining belonged priorities and transformed positions of the symbols according to a value of the index information FEC_payload_ID of the header of the recovery data packet and a number of the symbols with a corresponding priority; or

according to a priority field in the header of the recovery packet and the index information with a priority corresponding to the priority field, directly determining a belonged priority and a transformed position of the symbols;

adjusting a sequence of the symbols in the recovery data packet, and obtaining recovered intermediate data packet comprising a plurality of symbols after a decoding by a Gaussian elimination decoder and a RFC6330 decoder;

converting the intermediate data packet comprising the plurality of symbols into the intermediate packet.

A system for adaptive system code FEC encoding and decoding based on media content according to the present invention, comprising a server and at least one terminal, wherein, the server is configured to perform the method for adaptive system code FEC encoding and decoding based on media content according to any one of claims 7-10, the terminal is configured to perform the method for adaptive system code FEC encoding and decoding based on media content according to any one of claims 11-13.

A computer readable storage medium storing a computer program according to the present invention, when the computer program is executed by a processor, the steps of the image-based stripe cloth detection positioning and cutting method according to any one of claims 7 to 13 are performed.

Compared with the prior art, the present invention has the following beneficial effects: the method for adaptive system code FEC encoding and decoding based on media content according to the present invention, uses unequal error protection (UEP) to maximize the quality of the media content, and simultaneously reduce data redundancy caused by the FEC, by prioritizing the media content according to the importance thereof; makes encoding and decoding of the system code more flexible, without a need to offload the source data stream, thereby reducing the complexity of FEC encoding at the sending end, and improving the efficiency of FEC encoding; meanwhile, the coding scheme can be dynamically adjusted according to the change in current network state, so it has stronger adaptability to time-varying networks.

**Brief Description of the Drawings**

By reading the detailed description of the non-limiting embodiments with reference to the following drawings, other features, objects, and advantages of the present invention may become more apparent:

Fig. 1 is a schematic diagram of a two-layer structure of FEC for media resource data;
Fig. 2 and Fig. 3 are schematic diagrams of dependency relationships of each frame in an image group;
Fig. 4 is a schematic diagram of an unequal error protection coding scheme of a fountain code;
Fig. 5 is a schematic diagram of system architecture of fountain code unequal error protection;
Fig. 6 is a structure diagram of a coding matrix of a system RaptorQ code;
Fig. 7 is a structure diagram of a coding matrix of a system RaptorQ code with unequal error protection;
Fig. 8 is a structure diagram of a LT coding matrix with unequal error protection;
Fig. 9 is a flowchart of system fountain code encoding with a multi-priority unequal error protection;
Fig. 10 is a flowchart of system fountain code decoding with a multi-priority unequal error protection;
Fig. 11 is a schematic diagram of a system framework for adaptive system code FEC based on media content;
Fig. 12 is a schematic diagram of a mapping relationship of each priority;
Fig. 13 is a schematic diagram of reordering data packet flow according to priorities;
Fig. 14 is a flowchart of processing a source data packet and a recovery data packet after FEC encoding;
Fig. 15 is a schematic diagram of parsing signaling information and data packet information at a receiving end;
Fig. 16 is a schematic diagram of generating a coding matrix according to a received data packet;
Fig. 17 is a flowchart of processing a received data packet;
Fig. 18 is a schematic diagram of a result of recovering an initial sequence of data packet flow;
Fig. 19 is a schematic diagram of parsing information of a header of a data packet at a receiving end.

**Detailed Description**

The present invention is described in detail below with reference to specific embodiments. The following examples may help those skilled in the art to further understand the present invention, but do not limit the present invention in any form. It should be noted that for those of ordinary skill in the art, several changes and improvements can be made without departing from the concept of the present invention. These all belong to the protection scope of the present invention.

In the following, some terms in this application will be explained so as to facilitate understanding by those skilled in the art.

1) Unequal Error Protection (UEP) is a type of joint source channel coding. The core idea is that according to the importance of the data of each part of the code stream, different channel protection mechanisms are used for each part of the data, that is, provide focused protection for important code stream. Although UEP reduces the anti-noise performance of non-important code streams, it is beneficial to the improvement of overall error resistance of the system.

2) In the transmission of digital fountain code, no feedback and automatic retransmission mechanism are needed, which avoids the delay of signal round-trip and the problem of feedback explosion in broadcasting applications. The basic idea of a digital fountain is: the sending end divides an original data into k data symbols, encodes the data symbols, and outputs an encoded symbol code stream of any length. The receiving end only needs to correctly receive n (n is slightly larger than k) encoded symbols to recover all k data symbols with a high probability.

The digital fountain code itself has UEP performance, which can protect data of different importance. Compared with a traditional fixed-rate channel coding method, the digital fountain code has the following obvious advantages:

a. Ideal scalability. Since there is no feedback in the one-way broadcast, the sender is not affected by any increase in the number of users. The sender is enabled to serve any number of users.

b. Adapt to time-varying channels and use channel capacity efficiently. The decoding performance of a user is unrelated to the erasure probability and bandwidth of the channel. When the packet loss rate of the channel is high and the condition is not good, the decoding of the receiving end will not be affected, that is, the receiving end can decode normally after receiving a sufficient amount of encoded data, which has stronger adaptability.

c. The coding and decoding complexity is low. In an ideal condition, each encoded symbol generated by the fountain code has a linear coding and decoding complexity, which is helpful for simplifying the design and the software implementation of the encoder and decoder at the receiving end and the sending end.

d. Good applicability for heterogeneous users. The no-code-rate characteristic of the fountain code makes users with different packet loss rates or bandwidths not affect each other, high-quality users not restrained by low-quality users. In addition, the digital fountain code can support multiple service modes such as interrupted continuous transmission and asynchronous access.

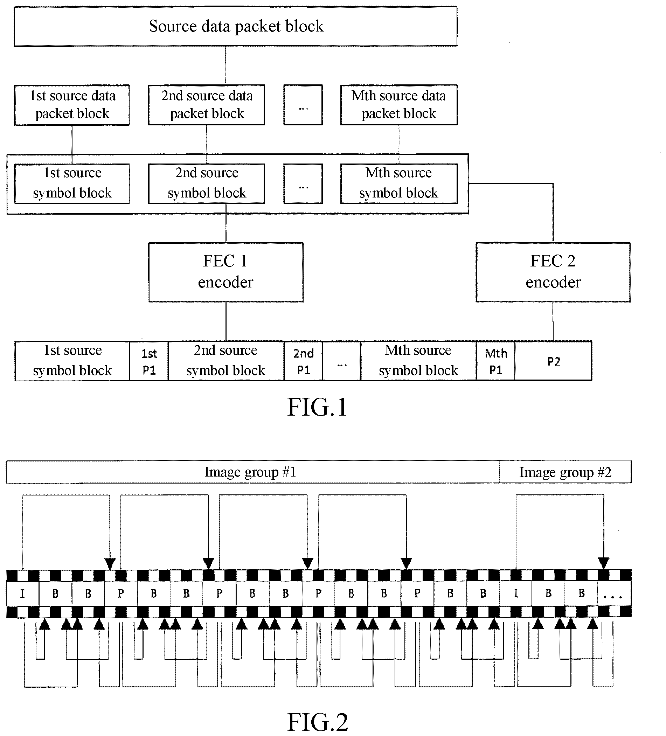

As shown in Fig. 1: For the two-layer structure of FEC for media resource data, the first layer divides the source packet block into more small blocks for FEC protection, and the second layer is a whole block for FEC protection. The fine division of the first layer may provide a less delay. The second layer guarantees a recovery performance and a less redundancy. However, this manner requires two FEC encodings, which reduces encoding efficiency and simultaneously lacks flexibility.

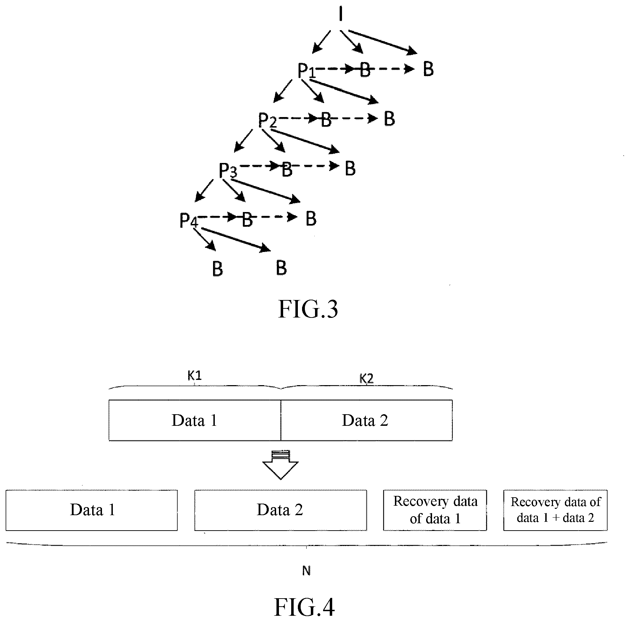

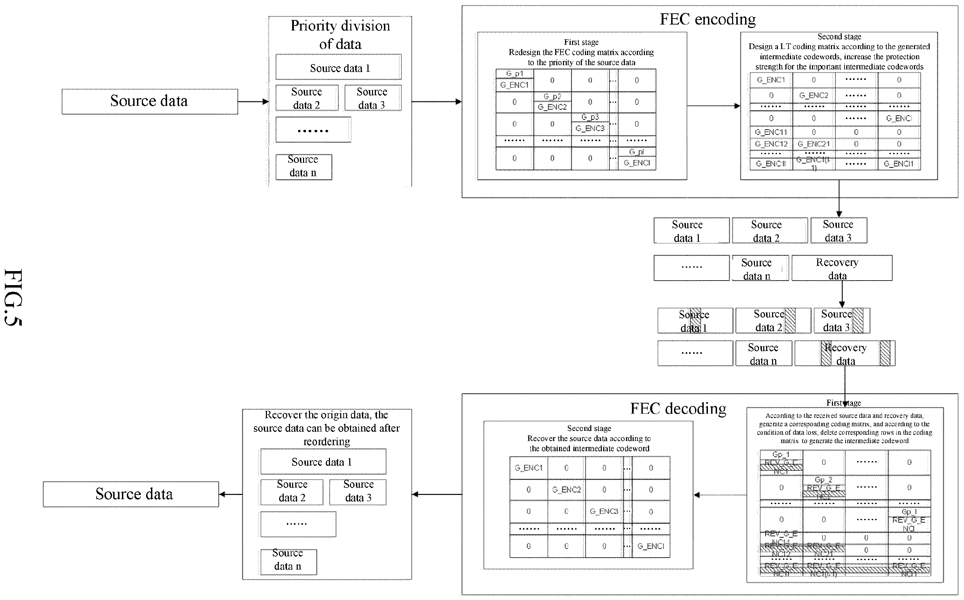

In a data stream, different types of data packets can be divided according to their content, and different types of data packets have different importance. For example, the importance of I, B and P frames in a data packet is shown in Fig. 2 and Fig. 3. The dependency relationship of each frame in one image group indicates that the dependency degree and importance of different frames in one image group are different. The frame I is most important, and the frame B and P are less important. Therefore, unequal error protection can be performed according to the importance of data content. Specifically considering the condition where the transmitted source data has two importance levels, the source data is divided according to the above standards, and reordered according to the importance. By changing the structure of the coding matrix of the system fountain code, unequal error protection for different contents is achieved. The basic architecture of the system is shown in Fig. 5. The data generated after the unequal error protection encoding of the system fountain code is shown in Fig. 4.

Embodiment 1

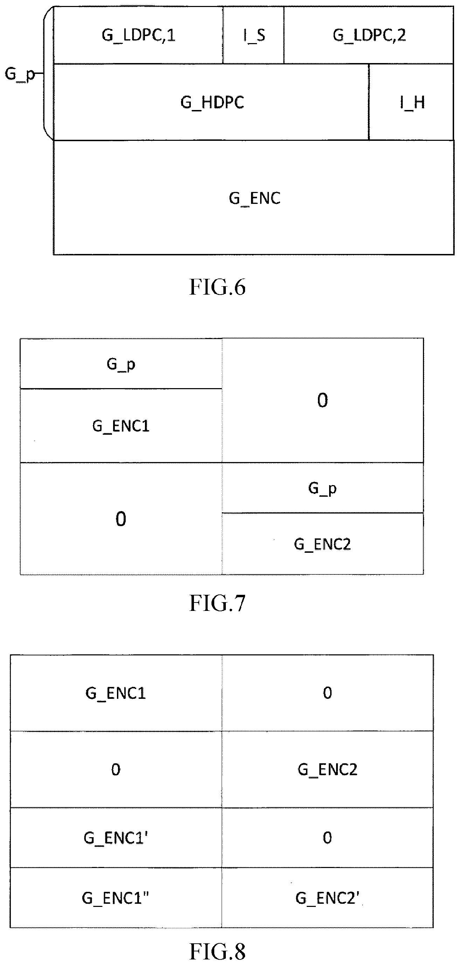

The embodiment takes the RaptorQ system code as an example. The structure of the coding matrix of the system RaptorQ code is shown in Fig. 6, wherein, D indicates a source data, C indicates an intermediate code, G LDPC indicates a LDPC matrix, I_S and I_H indicate identity matrices, and G_ENC indicates a LT coding matrix, then the coding matrix can be expressed as follows.

$$G\_p = \begin{bmatrix} G\_LDPC,1 & I\_S & G\_LDPC,2 \\ G\_HDPC & & I\_H \end{bmatrix} \tag{1}$$

$$A = \begin{bmatrix} G\_p \\ G\_ENC \end{bmatrix} \tag{2}$$

When FEC encoding is performed, an intermediate code is generated by the source data and the coding matrix shown in Fig. 6.

$$C = A^{-1} \times \begin{bmatrix} 0 \\ D \end{bmatrix} \tag{3}$$

Then, the source data and the recovery data are generated according to the LT matrix in the coding matrix and the obtained intermediate code. R indicates the recovery data obtained after encoding, and *G_ENC'* is a LT matrix having same generation manner as G_ENC.

$$\begin{bmatrix} D \\ R \end{bmatrix} = \begin{bmatrix} G\_ENC \\ G\_ENC' \end{bmatrix} \times C \qquad (4)$$

By adopting the above method to encode the source data, the source data cannot be prioritized and applied with unequal error protection encoding, so that the matrix structure of the coding matrix A and the LT matrix G ENC needs to be redesigned. Taking the source data having data with two different priorities therein as an example, assuming that the priorities are a priority of 1 and a priority of 2, the data with different priorities in the source data are separated for assigning different redundancy to achieve the effect of unequal error protection.

Encoding process:

The structure of the coding matrix is shown in Fig. 7. The coding matrix is shown in formula (6), wherein $G\_ENC_1$ and $G\_ENC_2$ are coding matrices generated by different rules. In order to ensure the protection of important data, the degree distribution of the matrix $G\_ENC_1$ can be improved.

$$A_i = \begin{bmatrix} G\_p_i \\ G\_ENC_i \end{bmatrix} \quad i = 1,2 \qquad (5)$$

$$A = \begin{bmatrix} G\_p_1 & 0 \\ G\_ENC_1 & 0 \\ 0 & G\_p_2 \\ 0 & G\_ENC_2 \end{bmatrix} \qquad (6)$$

In this way, corresponding intermediate codes can be generated for data of different importance levels.

$$\begin{bmatrix} C_1 \\ C_2 \end{bmatrix} = \begin{bmatrix} A_1^{-1} & 0 \\ 0 & A_2^{-1} \end{bmatrix} \begin{bmatrix} 0 \\ D_1 \\ 0 \\ D_2 \end{bmatrix} \qquad (7)$$

In order to achieve unequal error protection for data of different importance levels, it is also necessary to change the structure of the LT coding matrix as shown in Fig. 8 to add redundant data for protection of important data. $G\_ENC_1'$ is generated in same manner as $G\_ENC_1$, and $G\_ENC_2'$ and $G\_ENC_2$ are generated in same manner. The obtained recovery data R1 is only related to the data with a priority of 1, and the recovery data R is related to the data with priorities of 1 and 2. The redundancy of the important data is thereby increased, increasing its protection strength. Wherein, if the total redundancy of the data is limited due to the limitation of the channel conditions, the ratio of generating $R_1$ and $R_2$ is determined by the ratio of the number of rows of $[G\_ENC_1' \ 0]$ and $[G\_ENC_1'' \ G\_ENC_2]$. The number of rows of $[G\_ENC_1' \ 0]$ can be increased to further increase the protection strength of data with the priority of 1.

$$\begin{bmatrix} D_1 \\ D_2 \\ R_1 \\ R_2 \end{bmatrix} = \begin{bmatrix} G\_ENC_1 & 0 \\ 0 & G\_ENC_2 \\ G\_ENC_1' & 0 \\ G\_ENC_1'' & G\_ENC_2' \end{bmatrix} \begin{bmatrix} C_1 \\ C_2 \end{bmatrix} \qquad (8)$$

Decoding process:

Since some data packets are lost after passing through a lossy channel, according to the received symbols ISI, the matrix rows corresponding to the lost symbols ISI need to be erased to generate a recovery matrix. For example, for the matrix $REV\_G\_ENC_1$, the ISI of the lost data can be obtained according to the received $REV\_D_1$ and $D_1$ at the sending end, thereby deleting the corresponding rows of $G\_ENC_1$. Similar to the encoding process, during the first stage of decoding, an intermediate codeword is obtained according to the recovery matrix and the received data packet.

$$\begin{bmatrix} G\_p_1 & 0 \\ REV\_G\_ENC_1 & 0 \\ 0 & G\_p_2 \\ 0 & REV\_G\_ENC_2 \\ REV\_G\_ENC_1{}' & 0 \\ REV\_G\_ENC_1{}'' & REV\_G\_ENC_2{}' \end{bmatrix} \begin{bmatrix} C_1 \\ C_2 \end{bmatrix} = \begin{bmatrix} 0 \\ REV\_D_1 \\ 0 \\ REV\_D_2 \\ REV\_R_1 \\ REV\_R_2 \end{bmatrix} \qquad (9)$$

An elementary row transformation is performed on the above matrix equation to get the following form:

$$\begin{bmatrix} G\_p_1 & 0 \\ REV\_G\_ENC_1 & 0 \\ REV\_G\_ENC_1{}' & 0 \\ 0 & G\_p_2 \\ 0 & REV\_G\_ENC_2 \\ REV\_G\_ENC_1{}'' & REV\_G\_ENC_2{}' \end{bmatrix} \begin{bmatrix} C_1 \\ C_2 \end{bmatrix} = \begin{bmatrix} 0 \\ REV\_D_1 \\ REV\_R_1 \\ 0 \\ REV\_D_2 \\ REV\_R_2 \end{bmatrix}$$

$$(10)$$

Making $REV\_A = \begin{bmatrix} G\_p_1 & 0 \\ REV\_G\_ENC_1 & 0 \\ REV\_G\_ENC_1{}' & 0 \\ 0 & G\_p_2 \\ 0 & REV\_G\_ENC_2 \\ REV\_G\_ENC_1{}'' & REV\_G\_ENC_2{}' \end{bmatrix}$, according to the number of received data packets at each priority and the total number of received data packets, decoding is performed by various conditions.

The total number of received encoded symbols is less than the number of encoded symbols of the source data, and the number of rows is less than the number of columns in $REV\_A_1 = \begin{bmatrix} G\_p_1 \\ REV\_G\_ENC_1 \\ REV\_G\_ENC_1{}' \end{bmatrix}$; both $C_1$, $C_2$ are

unable to be solved.

The total number of received encoded symbols is less than the number of encoded symbols of the source data, but the number of rows is greater than or equal to the number of columns in $REV\_A_1 = \begin{bmatrix} G\_p_1 \\ REV\_G\_ENC_1 \\ REV\_G\_ENC_1{}' \end{bmatrix}$; if

the number of rows is greater than or equal to the number of columns in $REV\_A_1 = \begin{bmatrix} G\_p_1 \\ REV\_G\_ENC_1 \\ REV\_G\_ENC_1{}' \end{bmatrix}$, then

$REV\_A_1$ is invertible, and its inverse matrix is recorded as $REV\_A_1{}^{-1}$; then it can be obtained:

$$[C_1] = REV\_A^{-1} \begin{bmatrix} 0 \\ REV\_D_1 \\ REV\_R_1 \end{bmatrix}$$

$$(11)$$

but $C_2$ is unable to be solved.

The total number of received encoded symbols is greater than the number of encoded symbols of the source data, the number of rows is greater than or equal to the number of columns in $REV\_A_1 = \begin{bmatrix} G\_p_1 \\ REV\_G\_ENC_1 \\ REV\_G\_ENC_1{}' \end{bmatrix}$;

if the number of rows is greater than or equal to the number of columns in $REV\_A_1 = \begin{bmatrix} G\_p_1 \\ REV\_G\_ENC_1 \\ REV\_G\_ENC_1{}' \end{bmatrix}$,

$REV\_A_1$ then $REV\_A_1$ is invertible, and its inverse matrix is recorded as $REV\_A_1{}^{-1}$; if the number of rows is greater than or equal to the number of columns in $REV\_A_2 = \begin{bmatrix} G\_p_2 \\ REV\_G\_ENC_2 \\ REV\_G\_ENC_2{}' \end{bmatrix}$, then $REV\_A_2$ is invertible, and its inverse matrix is recorded as $REV\_A_2{}^{-1}$. If both $REV\_A_1$ and $REV\_A_2$ are invertible, then $REV\_A$ is invertible, and its inverse matrix is recorded as $REV\_A^{-1}$, recording $B_{1\_1} = \begin{bmatrix} 0 \\ 0 \\ REV\_G\_ENC_1{}'' \end{bmatrix}$, easy to know $REV\_A^{-1} =$

$\begin{bmatrix} REV\_A_1{}^{-1} & 0 \\ REV\_A_2{}^{-1}B_{1\_1}REV\_A_1{}^{-1} & REV\_A_2{}^{-1} \end{bmatrix}$. Then it can be obtained:

$$\begin{bmatrix} C_1 \\ C_2 \end{bmatrix} = REV\_A^{-1} \begin{bmatrix} 0 \\ REV\_D_1 \\ REV\_R_1 \\ 0 \\ REV\_D_2 \\ REV\_R_2 \end{bmatrix} = \begin{bmatrix} REV\_A_1{}^{-1} & 0 \\ REV\_A_2{}^{-1}B_{1\_1}REV\_A_1{}^{-1} & REV\_A_2{}^{-1} \end{bmatrix} \begin{bmatrix} 0 \\ REV\_D_1 \\ REV\_R_1 \\ 0 \\ REV\_D_2 \\ REV\_R_2 \end{bmatrix} \quad (12)$$

but if the number of rows is less than the number of columns in $REV\_A_2 = \begin{bmatrix} G\_p_2 \\ REV\_G\_ENC_2 \\ REV\_G\_ENC_2{}' \end{bmatrix}$, then $REV\_A_2$ does

not have an inverse matrix, and can only obtain $[C_1] = REV\_A^{-1} \begin{bmatrix} 0 \\ REV\_D_1 \\ REV\_R_1 \end{bmatrix}$.

The total number of received encoded symbols is greater than or equal to the number of encoded symbols of the source data, and the number of rows is less than the number of columns in $REV\_A_1 = \begin{bmatrix} G\_p_1 \\ REV\_G\_ENC_1 \\ REV\_G\_ENC_1' \end{bmatrix}$,

but the number of rows is greater than or equal to the number of columns in $REV\_A_2 = \begin{bmatrix} G\_p_2 \\ REV\_G\_ENC_2 \\ REV\_G\_ENC_2' \end{bmatrix}$;

using Gaussian elimination method to directly solve matrix $REV\_A$, that is, solving following linear equations:

$$\begin{bmatrix} G\_p_1 & 0 \\ REV\_G\_ENC_1 & 0 \\ REV\_G\_ENC_1' & 0 \\ 0 & G\_p_2 \\ 0 & REV\_G\_ENC_2 \\ REV\_G\_ENC_1'' & REV\_G\_ENC_2' \end{bmatrix} \begin{bmatrix} C_1 \\ C_2 \end{bmatrix} = \begin{bmatrix} 0 \\ REV\_D_1 \\ REV\_R_1 \\ 0 \\ REV\_D_2 \\ REV\_R_2 \end{bmatrix}$$

$$(13)$$

easy to obtain $C_1$, $C_2$.

It can be obtained from the first stage of the above decoding process that the correct solution of $C_1$ is first guaranteed in any conditions. Since the intermediate codewords $C_1$ and $C_2$ are important data to recover the source data in the second stage of decoding, the probability of correct recovery of the source data may be further increased by improving the decoding success rate of $C_1$.

According to the obtained intermediate codewords, generate the encoded symbols of the system code

$$\begin{bmatrix} D_1 \\ D_2 \end{bmatrix} = \begin{bmatrix} G\_ENC_1 & 0 \\ 0 & G\_ENC_2 \end{bmatrix} \begin{bmatrix} C_1 \\ C_2 \end{bmatrix}$$

$$(14)$$

If $C_1$ and $C_2$ are not obtained in the first stage, then the decoding fails and the source symbol cannot be decoded; if only $C_1$ is obtained, then the correct decoding of the prioritized source data $D_1$ can be guaranteed; if both $C_1$ and $C_2$ are obtained, then final source codes $D_1$ and $D_2$ can be obtained by using the above formula.

At the same time, the scheme is not only applicable to the scenario of two priorities, but also can be extended to the source data with a plurality of priorities. The specific process is as follows.

Encoding process:

First, according to the source data and the priority of the source data, an intermediate codeword is generated. Assume that the source data is divided into $I$ data packets, obtaining:

$$\begin{bmatrix} G\_p_1 & 0 & ... & 0 \\ G\_ENC_1 & 0 & ... & 0 \\ 0 & G\_p_2 & ... & 0 \\ 0 & G\_ENC_2 & ... & 0 \\ ... & ... & ... & ... \\ 0 & 0 & ... & G\_p_l \\ 0 & 0 & ... & G\_ENC_l \end{bmatrix} \begin{bmatrix} C_1 \\ C_2 \\ ... \\ C_l \end{bmatrix} = \begin{bmatrix} 0 \\ D_1 \\ 0 \\ D_2 \\ ... \\ 0 \\ D_l \end{bmatrix}$$

$$(15)$$

the intermediate codewords $C_1$, $C_2$, ..., $C_l$ can be obtained from equation (16).

$$\begin{bmatrix} C_1 \\ C_2 \\ ... \\ C_l \end{bmatrix} = \begin{bmatrix} A_1^{-1} & 0 & ... & 0 \\ 0 & A_2^{-1} & ... & 0 \\ ... & ... & ... & ... \\ ... & ... & ... & A_l^{-1} \end{bmatrix} \begin{bmatrix} 0 \\ D_1 \\ 0 \\ D_2 \\ ... \\ 0 \\ D_l \end{bmatrix}$$

$$(16)$$

The source data and the recovery data are generated according to the obtained intermediate codewords.

$$\begin{bmatrix} D_1 \\ D_2 \\ ... \\ D_l \\ R_1 \\ R_2 \\ ... \\ R_l \end{bmatrix} = \begin{bmatrix} G\_ENC_1 & 0 & ... & 0 \\ 0 & G\_ENC_2 & ... & 0 \\ ... & ... & ... & ... \\ 0 & 0 & ... & G\_ENC_l \\ G\_ENC_{11} & 0 & ... & 0 \\ G\_ENC_{12} & G\_ENC_{21} & ... & 0 \\ ... & ... & ... & ... \\ G\_ENC_{1l} & G\_ENC_{2(l-1)} & ... & G\_ENC_{l1} \end{bmatrix} \begin{bmatrix} C_1 \\ C_2 \\ ... \\ C_l \end{bmatrix}$$

$$(17)$$

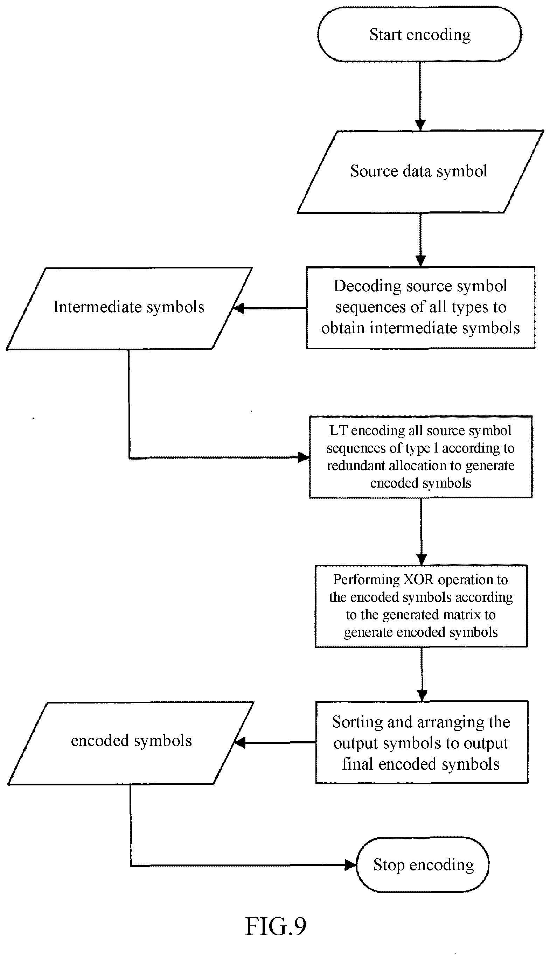

The entire encoding process is shown in Fig. 9. The source data and the recovery data are sent from a sending end to a receiving end. Due to the attenuation of the channel, some part of the data may be lost. After receiving the data, the receiving end decodes to recover the source data according to the received data.

Decoding process:

Due to the loss of some part of the data, a recovery matrix needs to be generated according to the received symbols ISI, which is equivalent to erasing the matrix rows corresponding to the lost symbols ISI to form a corresponding matrix, recorded as *REV_G_ENC*. According to the number difference of received data, intermediate codewords are generated at different conditions.

$$
\begin{bmatrix}
G\_p_1 & 0 & \dots & 0 \\
REV\_G\_ENC_1 & 0 & \dots & 0 \\
0 & G\_p_2 & \dots & 0 \\
0 & REV\_G\_ENC_2 & \dots & 0 \\
\dots & \dots & \dots & \dots \\
0 & 0 & \dots & G\_p_l \\
0 & 0 & \dots & REV\_G\_ENC_l \\
REV\_G\_ENC_{11} & 0 & \dots & 0 \\
REV\_G\_ENC_{12} & REV\_G\_ENC_{21} & \dots & 0 \\
\dots & \dots & \dots & \dots \\
REV\_G\_ENC_{1l} & REV\_G\_ENC_{2(l-1)} & \dots & REV\_G\_ENC_{l1}
\end{bmatrix}
\begin{bmatrix} C_1 \\ C_2 \\ \dots \\ C_l \end{bmatrix}
=
\begin{bmatrix}
0 \\ REV\_D_1 \\ 0 \\ REV\_D_2 \\ \dots \\ 0 \\ REV\_D_l \\ REV\_R_1 \\ REV\_R_2 \\ \dots \\ REV\_R_l
\end{bmatrix}
$$

(18)

Perform an elementary row transformation on the above matrix equation to get a following form:

$$
\begin{bmatrix}
G\_p_1 & 0 & \dots & 0 \\
REV\_G\_ENC_1 & 0 & \dots & 0 \\
REV\_G\_ENC_{11} & 0 & \dots & 0 \\
0 & G\_p_2 & \dots & 0 \\
0 & REV\_G\_ENC_2 \dots & \dots & \dots \\
REV\_G\_ENC_{12} & REV\_G\_ENC_{21} & \dots & 0 \\
\dots & \dots & \dots & \dots \\
0 & 0 & \dots & G\_p_l \\
0 & 0 & \dots & REV\_G\_ENC_l \\
REV\_G\_ENC_{1l} & REV\_G\_ENC_{2(l-1)} & \dots & REV\_G\_ENC_{l1}
\end{bmatrix}
\begin{bmatrix} C_1 \\ C_2 \\ \dots \\ C_l \end{bmatrix}
=
\begin{bmatrix}
0 \\ REV\_D_1 \\ REV\_R_1 \\ 0 \\ REV\_D_2 \\ REV\_R_2 \\ \dots \\ 0 \\ REV\_D_l \\ REV\_R_l
\end{bmatrix}
$$

(19)

Assuming

$$
REV\_A =
\begin{bmatrix}
G\_p_1 & 0 & \dots & 0 \\
REV\_G\_ENC_1 & 0 & \dots & 0 \\
REV\_G\_ENC_{11} & 0 & \dots & 0 \\
0 & G\_p_2 & \dots & 0 \\
0 & REV\_G\_ENC_2 \dots & \dots & \dots \\
REV\_G\_ENC_{12} & REV\_G\_ENC_{21} & \dots & 0 \\
\dots & \dots & \dots & \dots \\
0 & 0 & \dots & G\_p_l \\
0 & 0 & \dots & REV\_G\_ENC_l \\
REV\_G\_ENC_{1l} & REV\_G\_ENC_{2(l-1)} & \dots & REV\_G\_ENC_{l1}
\end{bmatrix}
,
$$

assuming that $R(i)(1 \le i \le l)$ is the symbol number of level i after received and extended, $L(i)$ is the symbol length of each level at the encoding end, for i = 1:l, the rank of a generated matrix of each level eachRank(i) = min(Len(R(i)), sum(L(1: i))) is calculated; then the rank of an accumulated matrix cumRank(i) = min(cumRank(i - 1) + eachRank(i), sum(L(1: i))) is calculated, wherein cumRank(1) = eachRank(1). cumRank(i) >= *sum(L(1:i))* is judged in order: if it is true, cumFull-Rank(i) = 1; otherwise cumFullRank(i) = 0. The following is to respectively obtain the intermediate codes $C_1, C_2, \dots C_l$ according to the received symbol number of each level according to conditions, setting a initial value of i to 1:
If cumFullRand(i) == 1&&cumFullRank(1: i) > 0 is satisfied, using RFC 6330 decoding method to solve C(1)~C(i)

Assuming

$$REV\_A_{\Delta i} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix},$$

and easy to know $REV\_A_{\Delta i}^{-1} = \begin{bmatrix} A_1^{-1} & 0 & 0 & 0 \\ X_{1\_2} & A_2^{-1} & 0 & 0 \\ ... & ... & ... & 0 \\ X_{1\_i} & X_{2\_(i-1)} & ... & A_{i\_1}^{-1} \end{bmatrix}$, wherein $X_{1\_2} = A_2^{-1}B_{1\_2}A_1^{-1}$,

$X_{a\_b} = A_b^{-1}B_{a\_b}A_a^{-1} + \sum_{k=a+1}^{b-1} A_b^{-1} B_{k\_b}X_{a\_k}$, the intermediate code can be further obtained by the following formula:

$$C_{i\_temp} = REV\_A_i^{-1}\begin{bmatrix} 0 \\ REV\_D_i \\ REV\_R_i \end{bmatrix},$$

$$C_1 = C_{1\_temp}$$

$$C_2 = C_{2\_temp} + X_{1\_2}\begin{bmatrix} 0 \\ REV\_D_1 \\ REV\_R_1 \end{bmatrix} = C_{2\_temp} + A_2^{-1}B_{1\_2}C_1$$

$$C_3 = C_{3\_temp} + X_{1\_3}\begin{bmatrix} 0 \\ REV\_D_1 \\ REV\_R_1 \end{bmatrix} + X_{2\_3}\begin{bmatrix} 0 \\ REV\_D_2 \\ REV\_R_2 \end{bmatrix} = C_{2\_temp} + A_3^{-1}B_{1\_3}C_1 + A_3^{-1}B_{2\_3}C_2$$

$$\ldots \text{(mathematical induction)}$$

$$C_i = C_{i\_temp} + \sum_{j=1}^{i-1} X_{j\_i}\begin{bmatrix} 0 \\ REV\_D_j \\ REV\_R_j \end{bmatrix} = C_{i\_temp} + \sum_{j=1}^{i-1} A_i^{-1}B_{j\_i} C_j$$

obtaining $C_1$, $C_2$ ... $C_i$, while other $C_{i+1}$ ... $C_l$ cannot be obtained.

If cumFullRand(i) == 1 is satisfied, but cumFullRank(1:i) > 0 is not satisfied, use Gaussian elimination method to solve C(1)~C(i)

Assuming

$$REV\_A_{\Delta i} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix},$$

the linear equations can be solved by Gaussian elimination method:

$$\begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix} \begin{bmatrix} C_1 \\ C_2 \\ ... \\ C_i \end{bmatrix} = \begin{bmatrix} 0 \\ REV\_D_1 \\ REV\_R_1 \\ 0 \\ REV\_D_2 \\ REV\_R_2 \\ ... \\ 0 \\ REV\_D_i \\ REV\_i \end{bmatrix} \quad (20)$$

obtaining $C_1$, $C_2$ ... $C_i$, while other $C_{i+1}$ ... $C_l$ cannot be obtained.

For a certain value of i, if cumFullRand(i) == 1 is not satisfied, then the corresponding $C_i$ cannot be solved. Until i == 1, the above two conditions cannot be satisfied, then none of $C_1$, $C_2$ ... $C_l$ can be solved, and the decoding fails.

Make i = i-1 to continue the loop, that is, i=1:-1: 1, and repeat the above process.

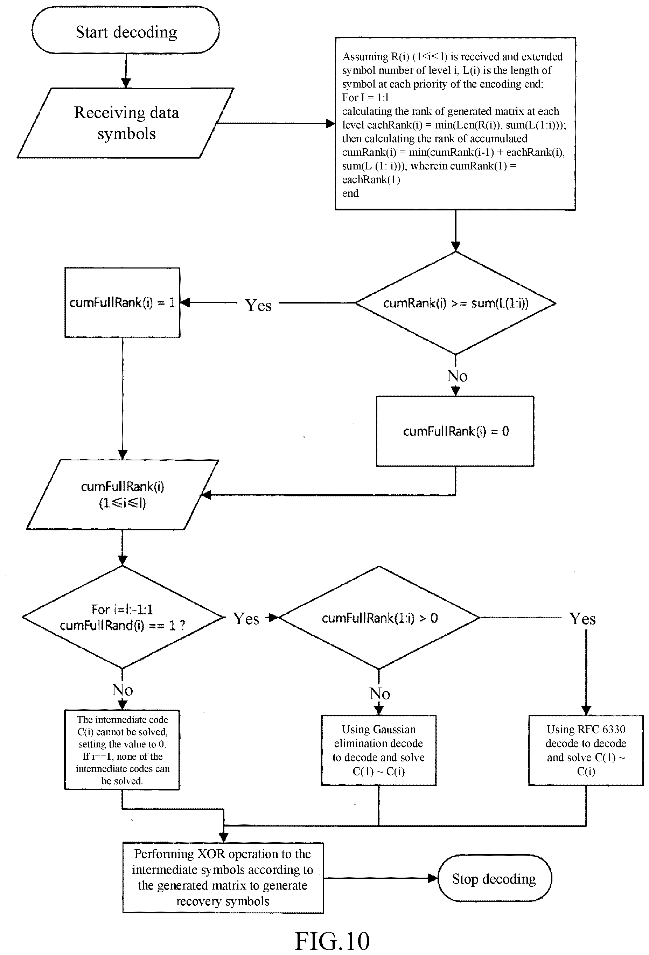

The entire decoding process is shown in Fig. 10.

The method in the embodiment can effectively save resources. If the received data (such as B-frames) is artificially discarded according to the condition at the receiving end, a waste of transmission resources will be caused. The above scheme solves the problem from the source side, making unwanted packets be dropped with greater probability during transmission, and protecting important packets to a greater extent.

The method in the embodiment implements a personalized transmission scheme. Unequal error protection schemes can be designed according to channel conditions, user experience, etc., making video transmission more flexible and finer. At the same time, despite the flexible encoding method at the sending end, the receiving end can correctly recover the original data according to the list information.

The method in the embodiment provides a more flexible design of the coding matrix. The data can be prioritized based on the media content, according to the application scenario of the actual media, and the FEC coding matrix can be more flexibly designed according to the actual needs to achieve the effect of unequal error protection.

The method in the embodiment implements s a more flexible decoding manner. According to the number of received data at each priority, different decoding algorithms can be used, so that the data with a high priority can be recovered to the greatest extent with the limited bandwidth resources, improving the protection strength for the data with a higher priority.

Embodiment 2

Each sub-packet in the source data packet may be mapped to a different preset priority, or Embodiment 1 and Embodiment 2 may be combined. Specifically as follows:

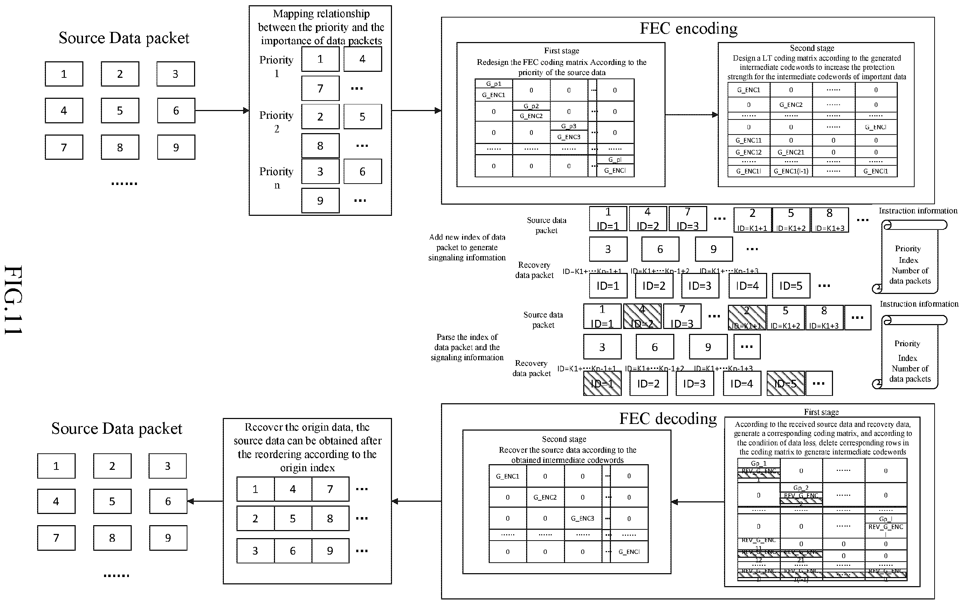

Fig. 11 is a schematic diagram of a system framework for adaptive system code FEC based on media content, comprising a server and at least one terminal. First, the server side divides a plurality of priorities according to the actual application scenarios and the media content, parsing the importance information about the data packet in a header of the packet to map each data packet to a different priority. Secondly, according to a priority condition and a mapping relationship, all the data packets that need to be forward error correction (FEC) encoded are rearranged according to the priority from high to low. The rearranged source data, according to the actual channel conditions, is encoded, by using the FEC coding method with unequal error protection, to generate recovery data (repair symbols). After finishing the FEC encoding, an index field, indicating the sequence of the current data packet, is added in the source data packets and the recovery data packets. The source data and the recovery data at each priority are counted to generate corresponding signaling information. The signaling indicates the number or the ratio of data packets at each priority, and the number or the ratio of corresponding recovery data at each priority, so that the receiving end can recover the data correctly after receiving the data. Finally, the source data packets, the recovery data packets, and the signaling are sent to the terminal (a client or a receiving end).

Correspondingly, the terminal side first parses the signaling information and the index fields in the received data packets to obtain the number of received source data packets and recovery data packets at each priority and corresponding data packet indexes. Second, according to the obtained packet index information, a coding matrix is generated at the receiving end. Finally, according to the generated coding matrix, FEC decoding is performed for different conditions, and the source data packets are recovered. Since the sequence of the recovered source data packets is a reordered order, by parsing the sequence of the source data packets in the header of data packet, and rearranging the source data packets, the original data of the source data packets is obtained.

The technical proposal of the present invention will be described in detail in the following specific embodiments. The following specific embodiments may be combined with each other, and the same or similar concepts or processes may not be repeated in some embodiments.

Embodiment 2.1

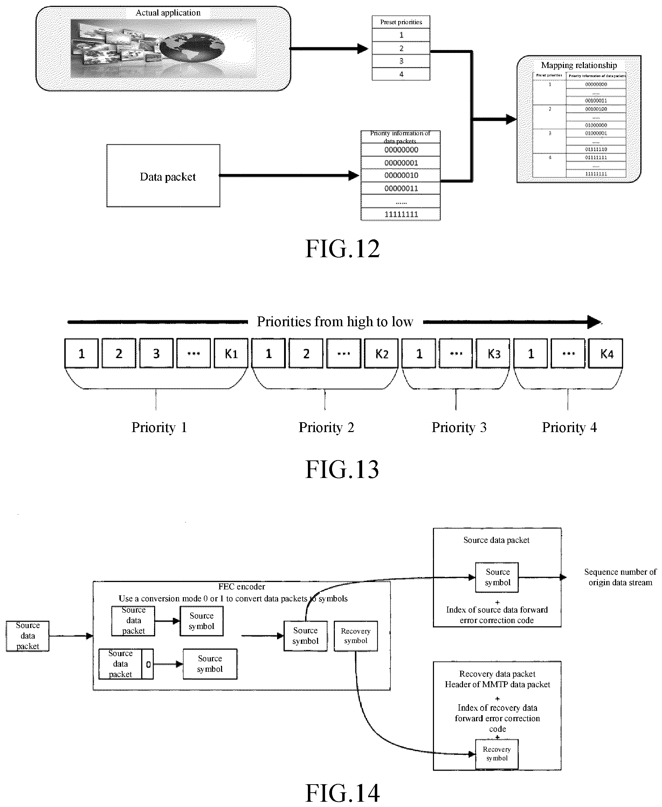

As shown in Fig. 12, the following steps may be comprised:

S1: Parse the header of the encoded and encapsulated data packet, read the priority field in the DU header, and determine the actual number of adopted priorities and the mapping relationship with the priority field at each priority according to actual applications.

S2: According to the divided priorities and the mapping relationship, reorder the original source data stream according to the priority from high to low, and count the number of data packets at each priority, as shown in Fig. 13.

S3: Perform FEC encoding on the reordered source data stream, by using the adaptive FEC encoding scheme with the system RaptorQ system code, to generate a recovery data.

Specifically, perform FEC encoding on the intermediate data packet, by using the adaptive FEC encoding scheme with the system RaptorQ system code, to obtain the following intermediate codeword:

$$
\begin{bmatrix} C_1 \\ C_2 \\ ... \\ C_N \end{bmatrix} = \begin{bmatrix} A_1^{-1} & 0 & ... & 0 \\ 0 & A_2^{-1} & ... & 0 \\ ... & ... & ... & ... \\ ... & ... & ... & A_N^{-1} \end{bmatrix} \begin{bmatrix} 0 \\ D_1 \\ 0 \\ D_2 \\ ... \\ 0 \\ D_N \end{bmatrix}
$$

in the formula: $A_i$ indicates a coding matrix corresponding to a source data packet of type $i$, $C_1, C_2, ..., C_i ..., C_N$ respectively correspond to an intermediate code of the N types of the source data packets, $D_1, D_2, ..., D_i ..., D_N$ respectively correspond to a data of the N types of the source data packets, superscript -1 is an inverse matrix operator;

according to the intermediate codeword, a recovery data packet is obtained, and a FEC payload ID is added to the recovery data packet, wherein, the recovery data in the recovery data packet is as follows:

$$\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\,(N-1)}} & ... & G_{ENC_{N1}} \end{bmatrix} \begin{bmatrix} C_1 \\ C_2 \\ ... \\ C_N \end{bmatrix}$$

in the formula: $R_1$, $R_2$, ..., $R_i$ ..., $R_N$ respectively correspond to a recovery data of 1~N source data packets, $G\_ENC_i$ indicates a LT coding matrix corresponding to an *i-th* source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

According to the data stream (reordered data stream) output from a FEC encoder, source packets and recovery packets are generated, plus the FEC payload ID, as shown in Figure 14.

S4: Generate an AL-FEC message, indicating the number of data packets at each priority and the number of corresponding recovery data packets at each priority in the signaling, so that the receiving end can recover the data correctly after receiving the data. A specific signaling is shown in Table 1.

Table 1 Signaling information comparison

| Grammar | Value | Number of bits | Notes |
|---|---|---|---|
| if (fec_coding_structure == 0100) { | | | |
| number_of priority | N8 | | uimbsf |
| for(i=0;i<N8;i++){ | | | |
| fec_priority_value | | 8 | uimbsf |
| number_of_source_symbol | | 16 | uimbsf |
| number_of_repair_symbol | | 16 | uimbsf |
| } | | | |
| | | | |
| if (private fec flag == 1) { | | | |
| private_flag | N7 | 1 | bslbf |
| private_field_length | | 7 | bslbf |
| private_field | | N78 | uimbsf |
| } | | | |
| repair_flow_id | | 8 | uimbsf |
| fec_code_id_for_repair_flow | | 8 | uimbsf |
| maximum_k_for_repair_flow | | 24 | uimbsf |
| maximum_p_for_repair_flow | | 24 | uimbsf |
| protection_window_time | | 32 | uimbsf |
| protection_window_size | | 32 | uimbsf |
| } | | | |

In Table 1, the number_of_priority: indicating the number of priorities. The fec_priority_value: 8 bits, indicating the value corresponding to each priority. The value can be at most same as the priority defined in the DU header, or can correspond to the priority in a plurality of DU headers. The number_of_source_symbol: 16 bits, indicating the number of source symbols at the priority indicated by the fec_priority_value. The number of repair symbol: 16 bits, indicating the number of recovery symbols at the priority indicated by fec_priority_ value. The private fec flag: an indicator bit, indicating whether to use a private FEC encoding scheme. The private flag: an indicator bit, indicating whether there is a private_field describing the used private FEC encoding scheme. The private field length: a length field, used to describe the length of the field for the private FEC encoding scheme. The private field: used to describe the details of the private FEC scheme. The priority_id: id of priority, used to indicate the priority of a MMT packet. The fec_code_id_for_repair_flow: used to describe the used FEC encoding scheme. The repair_flowid: an 8-bit integer, used to indicate the generated FEC repair flow, which corresponds to the packet id in the header of the FEC repair packet. The maximum_k_for_repair_flow: a 24-bit integer, describing the maximum number of source symbols in a source sysmbol block. The maximum_p_for_repair_flow: a 24-bit integer, describing the maximum number of repair symbols in a repair sysmbol block. The protection window time: the time of protection window, indicating the maximum time difference between the source or repair packet sent first and the source or repair packet sent last in FEC encoding, in milliseconds. The protection_window_size: the value of the protection window, indicating the maximum count between the load of the FEC packet sent first and the load of the FEC packet sent last in the FEC code stream.

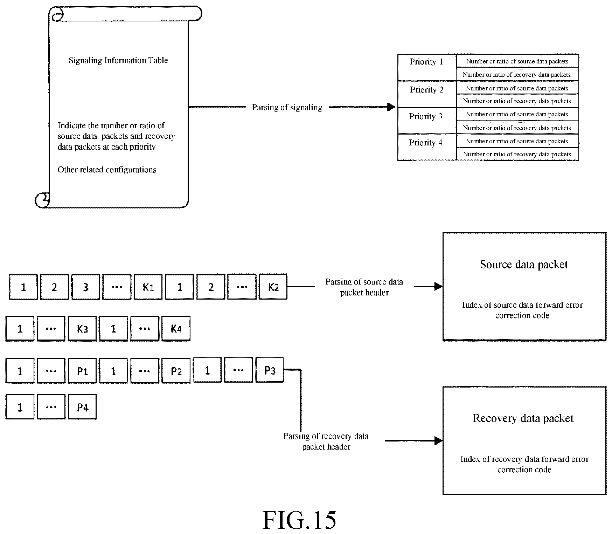

As shown in Fig. 15, according to the number of data packets at each priority of the FEC, a corresponding row index of the coding matrix corresponding to the source data is obtained by the following formula:

$$index = FEC\ payload\ ID - $$

$$number\ of\ packets\ of\ all\ priorities\ before\ this\ packet.$$

in the formula: the index indicates a corresponding row index of the coding matrix corresponding to the source data, the FEC payload ID indicates index information of the header of the data packet, the number of packets of all priorities before this packet: indicates a total number of data packets of all priorities before the packet.

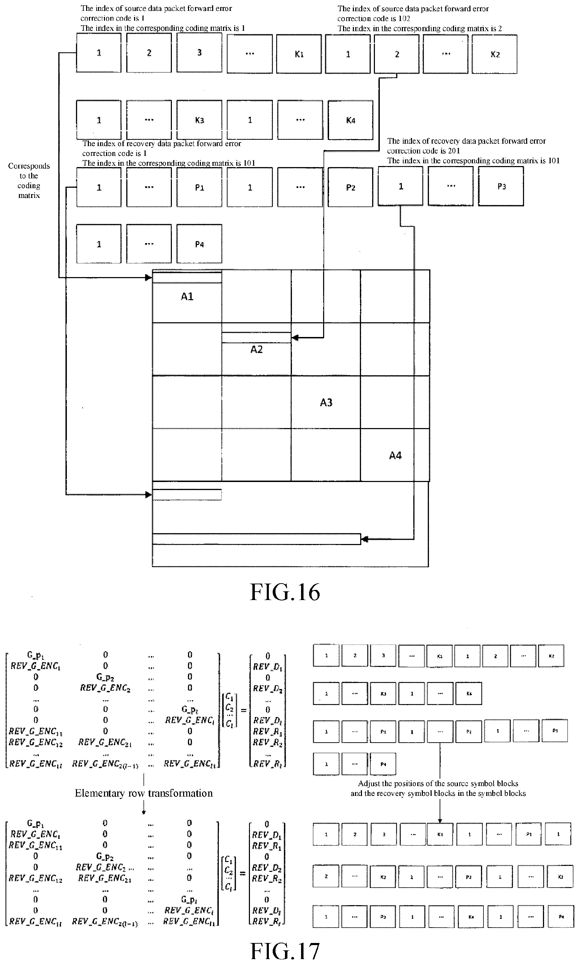

Now, it is illustrated by taking four priorities, the number of each priority being 100, as an example, as shown in Fig. 16. The source_FEC_payload_ID is sorted according to the sequence of the reordered source data packets, and for the one with a priority of 1, the ISI (index) of the generated coding matrix can be directly determined according to the current source FEC_payload_ID. If the priority is greater than 1, when parsing the packet header, according to the value of its source_FEC_payload_ID and the number of data of source symbols at each priority, what priority it belongs to can be determined. For example, source_FEC_payload_ID = 108, then it can determine that it belongs to the priority of 2, and its ISI = 8 can be obtained by the above formula. For the recovery data packet, it can determine its ISI in the generated matrix according to the repair_FEC_payload_ID in the packet header. Since the sending end and the receiving end use same FEC coding mechanism, a corresponding coding matrix can be generated according to the above two indexes.

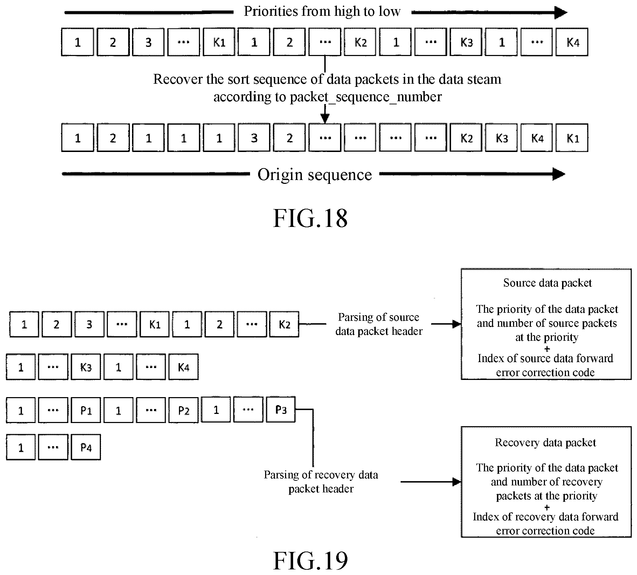

According to the generated FEC coding matrix, an elementary row transformation is performed on the coding matrix, and the corresponding received data packets are sorted. According to the value of the repair_FEC_payload_ID and the number of data of recovery symbols at each priority, which priority it belongs to is determined, thereby adjusting the position of the recovery symbols in the symbol block to achieve the same change, as shown in Fig. 17. According to the number difference of received data packets with different priorities, decoding is performed for a plurality of conditions, whose flowchart is shown in Fig. 10. Finally, the recovered source data is obtained, and then the obtained source data packets are recovered to the initial sequence according to the packet sequence number in the packet header, specifically shown in Fig. 18.

Embodiment 2.2: As shown in Fig. 12, the following steps may be comprised:

S1: Parse the header of the encoded and encapsulated data packet, read the priority field in the DU header, and determine the actual number adopted priorities and the mapping relationship with the priority field at each priority according to actual applications.

S2: According to the divided priorities and the mapping relationship, reorder the original source data stream according to the priority from high to low, and count the number of data packets at each priority, as shown in Fig. 13.

S3: Perform FEC encoding on the reordered source data stream, by using the adaptive FEC encoding scheme with the system RaptorQ system code, to generate a recovery data.

Specifically, perform FEC encoding on the intermediate data packet, by using the adaptive FEC encoding scheme with the system RaptorQ system code, to obtain the following intermediate codeword:

$$
\begin{bmatrix} C_1 \\ C_2 \\ ... \\ C_N \end{bmatrix} = \begin{bmatrix} A_1^{-1} & 0 & ... & 0 \\ 0 & A_2^{-1} & ... & 0 \\ ... & ... & ... & ... \\ ... & ... & ... & A_N^{-1} \end{bmatrix} \begin{bmatrix} 0 \\ D_1 \\ 0 \\ D_2 \\ ... \\ 0 \\ D_N \end{bmatrix}
$$

in the formula: $A_i$ indicates a coding matrix corresponding to a source data packet of type $i$, $C_1$, $C_2$, ..., $C_i$ ..., $C_N$ respectively correspond to an intermediate code of the N types of the source data packets, $D_1$, $D_2$, ..., $D_i$ ..., $D_N$ respectively correspond to a data of the N types of the source data packets, superscript -1 is an inverse matrix operator;

according to the intermediate codeword, a recovery data packet is obtained, and a FEC payload ID is added to the recovery data packet, wherein, the recovery data in the recovery data packet is as follows:

$$
\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\,(N-1)}} & ... & G_{ENC_{N1}} \end{bmatrix} \begin{bmatrix} C_1 \\ C_2 \\ ... \\ C_N \end{bmatrix}
$$

in the formula: $R_1$, $R_2$, ..., $R_i$ ..., $R_N$ respectively correspond to a recovery data of 1~N source data packets, $G\_ENC_i$ indicates a LT coding matrix corresponding to an $i$-th source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

S4: Generate corresponding instruction information in the header extension of data packets, indicating the number of packets at each priority, and the number of corresponding recovery packets at each priority, so that the receiving end can recover the data correctly after receiving the data. The details are shown in Table 2.

Table 2

```
 0                   1                   2                   3
 0 1 2 3 4 5 6 7 8 9 0 1 2 3 4 5 6 7 8 9 0 1 2 3 4 5 6 7 8 9 0 1
+-+-+-+-+-+-+-+-+-+-+-+-+-+-+-+-+-+-+-+-+-+-+-+-+-+-+-+-+-+-+-+-+
|            type           |              length               |
+-+-+-+-+-+-+-+-+-+-+-+-+-+-+-+-+-+-+-+-+-+-+-+-+-+-+-+-+-+-+-+-+
|          N        |                 SSBL[1]                   |
+-+-+-+-+-+-+-+-+-+-+-+-+-+-+-+-+-+-+-+-+-+-+-+-+-+-+-+-+-+-+-+-+
|                SSBL[2]                |      ......           |
+-+-+-+-+-+-+-+-+-+-+-+-+-+-+-+-+-+-+-+-+-+-+-+-+-+-+-+-+-+-+-+-+
|       SSBL[N]             |              RSBL[1]              |
+-+-+-+-+-+-+-+-+-+-+-+-+-+-+-+-+-+-+-+-+-+-+-+-+-+-+-+-+-+-+-+-+
|     RSBL[1]      |                 RSBL[2]                    |
+-+-+-+-+-+-+-+-+-+-+-+-+-+-+-+-+-+-+-+-+-+-+-+-+-+-+-+-+-+-+-+-+
|         ......           |             RSBL[N]                |
+-+-+-+-+-+-+-+-+-+-+-+-+-+-+-+-+-+-+-+-+-+-+-+-+-+-+-+-+-+-+-+-+
```

In Table 2, the type: 16 bits, indicating the type of the current packet header extension. Here, it indicates an intermediate data packet or a recovery data packet used for adaptive forward error correction coding. The length: 16 bits, used to indicate the length of header extension. The FEC_priority: 8 bits, used to indicate the priority to which the current packet belongs. The sub_encoded_symbol_id: 16 bits, used to indicate the index of the number of intermediate data packets or recovery data packets at the priority. The N: 8 bits, used to indicate the total number of priorities. The SSBL[i]: 24 bits, i indicates the i-th priority, used to indicate the number of source data packets at each priority. The RSBL[i]: 24 bits, i indicates the i-th priority, used to indicate the number of recovery data packets at each priority.

As shown in Fig. 19, according to the number of data packets at each priority of the FEC, the corresponding row index of the coding matrix corresponding to the source data is obtained by the following formula:

$$index = FEC\ payload\ ID -$$

$$number\ of\ packets\ of\ all\ priorities\ before\ this\ packet.$$

in the formula: the index indicates a corresponding row index of the coding matrix corresponding to the source data, the FEC payload ID indicates index information of the header of the data packet, the number of packets of all priorities before this packet: indicates a total number of data packets of all priorities before the packet.

According to the generated FEC coding matrix, an elementary row transformation is performed on the coding matrix, and the corresponding received data packets are sorted. According to the value of the repair_FEC_payload_ID and the number of data of recovery symbols at each priority, which priority it belongs to is determined, thereby adjusting the position of the recovery symbols in the symbol block to achieve the same change, as shown in Fig. 17. According to the number difference of received data packets with different priorities, decoding is performed for a plurality of conditions, whose flowchart is shown in Fig. 10. Finally, the recovered source data is obtained, and then the obtained source data packets are recovered to the initial sequence according to the packet sequence number in the packet header, specifically shown in Fig. 18.

In the embodiment, the server side provides different protection for data of different importance by dividing the importance of different data in the data stream. It is identified by the header information and signaling information of the sent data packet. The system code method is used to adaptively adjust the coding matrix of the system fountain code according to the channel conditions and the importance of the data, so as to achieve unequal error protection for data of different importance. The terminal side parses the signaling information and packet header information, and simultaneously uses a flexible decoding algorithm to achieve flexible coding and decoding, according to the number of received data with different priorities, and finally recovers the source data stream according to the packet header information. Therefore, the following beneficial effects can be achieved:

1) Save resources. For example, on the terminal side (a receiving end), artificially discarding the received data (such as B frames) according to the condition may cause a waste of transmission resources. The method in the embodiment solves the problem from the source end, making unwanted packets be dropped with greater probability during transmission, thereby protecting important packets to a greater extent.

2) Implement a personalized transmission scheme. For example, unequal error protection schemes can be designed according to channel conditions, user experience, etc., making video transmission more flexible and detailed. In addition, despite the flexible encoding method at the sending end, the receiving end can correctly recover the original data according to the list information.

3) Achieve a more flexible design of the coding matrix. For example, the data can be prioritized based on the media content, according to the application scenario of the actual media, and the FEC coding matrix can be more flexibly designed according to the actual needs to achieve the effect of unequal error protection.

4) Implement a more flexible decoding method. For example, according to the number of received data at each priority, different decoding algorithms can be used, so that the data with a high priority can be recovered to the greatest extent with the limited bandwidth resources, improving the protection strength for the data with a higher priority.

It should be noted that the steps in the method for adaptive system code FEC encoding and decoding based on media content may use corresponding modules, devices, units, etc. in the system for adaptive system code FEC encoding and decoding based on media content to be implemented. Those skilled in the art may refer to the technical proposal of the system to implement the steps and procedures of the method, that is, the embodiments in the system may be understood as the preferred examples of implementing the method, which will not be repeated here.

In addition, the present invention may be applied to a computer readable storage medium. The computer readable storage medium stores a computer program. When the computer program is executed by a processor, the steps of the method for adaptive system code forward error correction (FEC) encoding and decoding based on media content described in the foregoing embodiment are implemented.

Those skilled in the art know that, in addition to implementing the system and its various devices, modules and units, provided by the present invention, in a pure computer readable program code manner, it is entirely possible to make the system and its various devices, modules and units, provided by the present invention, implement same functions by logically programming the method steps, in forms of logic gates, switches, application specific integrated circuits, programmable logic controllers and embedded microcontrollers, etc. Therefore, the system and its various devices, modules and units, provided by the present invention, can be considered as a kind of hardware components, and the devices, modules and units comprised in them for implementing various functions can also be considered as structures in the hardware components; and the devices, modules and units for implementing various functions can also be considered as software modules for implementing the method and structures in the hardware components.

The specific embodiments of the present invention have been described above. It should be understood that the present invention is not limited to the specific embodiments described above, and those skilled in the art can make various changes or modifications within the scope of the claims, which does not affect the essence of the present invention. In conditions of no conflict, the embodiments of the present application and the features in the embodiments can be arbitrarily combined with each other.

**Claims**

1.  A method for adaptive system code FEC encoding and decoding based on media content, **characterized in that** it comprises:

    according to importance of media content, dividing a source data into N types of source data packets according to priorities; the N is an integer greater than 1;
    according to the source data and priorities of the N types of the source data packets, generating N types of intermediate codes;
    according to the N types of the intermediate codes, setting recovery data of the N types of the source data according to a channel condition, generating N types of encoded symbols;
    receiving the encoded symbols, sorting and arranging the coding symbols according to a decoding requirement, decoding the encoded symbols;
    according to a condition of received encoded symbols, decoding to obtain preferentially the intermediate code with a high priority, and recovering corresponding source data packets according to the intermediate code.

2.  The method for adaptive system code FEC encoding and decoding based on media content of claim 1, **characterized in that** the according to the source data and priorities of the N types of the source data packets, generating N types of intermediate codes comprises:

    constructing a coding matrix corresponding to the N types of the source data packets, recorded as $A_i$, $i$ = 1, 2, ... N; wherein:

$$A_i = \begin{bmatrix} G\_p_i \\ G\_ENC_i \end{bmatrix} \quad i = 1, 2, \dots N$$

    in the formula: $A_i$ indicates a coding matrix corresponding to an *i-th* source data packet, $G\_p_i$ indicates a joint matrix composed of a LDPC matrix and an identity matrix and corresponding to the *i-th* source data packet, $G\_ENC_i$ indicates a LT coding matrix corresponding to the *i-th* source data packet;
    constructing a coding matrix A of the source data according to the coding matrix corresponding to the N types of the source data packets, the coding matrix of the source data is as follows:

$$A = \begin{bmatrix} \mathrm{G\_p}_1 & 0 & ... & 0 \\ G\_ENC_1 & 0 & ... & 0 \\ 0 & \mathrm{G\_p}_i & ... & 0 \\ 0 & G\_ENC_i & ... & 0 \\ ... & ... & ... & ... \\ 0 & 0 & ... & \mathrm{G\_p}_N \\ 0 & 0 & ... & G\_ENC_N \end{bmatrix}$$

$$A \begin{bmatrix} C_1 \\ C_2 \\ ... \\ C_i \\ ... \\ C_N \end{bmatrix} = \begin{bmatrix} 0 \\ D_1 \\ 0 \\ ... \\ D_i \\ ... \\ 0 \\ D_N \end{bmatrix}$$

then

$$\begin{bmatrix} C_1 \\ C_2 \\ ... \\ C_N \end{bmatrix} = \begin{bmatrix} A_1^{-1} & 0 & ... & 0 \\ 0 & A_2^{-1} & ... & 0 \\ ... & ... & ... & ... \\ ... & ... & ... & A_N^{-1} \end{bmatrix} \begin{bmatrix} 0 \\ D_1 \\ 0 \\ D_2 \\ ... \\ 0 \\ D_N \end{bmatrix}$$

in the formula: $C_1$, $C_2$ ..., $C_i$ ..., $C_N$ respectively correspond to the intermediate code of the N types of the source data packets, $D_1$, $D_2$, ..., $D_i$ ..., $D_N$ respectively correspond to data of the N types of the source data packets, superscript -1 is an inverse matrix operator.

3. The method for adaptive system code FEC encoding and decoding based on media content of claim 2, **characterized in that** the according to the N types of the intermediate codes, setting recovery data of the N types of the source data according to a channel condition, comprises:

$$\begin{bmatrix} D_1 \\ D_2 \\ ... \\ D_N \\ R_1 \\ R_2 \\ ... \\ R_N \end{bmatrix} = \begin{bmatrix} G\_ENC_1 & 0 & ... & 0 \\ 0 & G\_ENC_2 & ... & 0 \\ ... & ... & ... & ... \\ 0 & 0 & ... & G\_ENC_N \\ G\_ENC_{11} & 0 & ... & 0 \\ G\_ENC_{12} & G\_ENC_{21} & ... & 0 \\ ... & ... & ... & ... \\ G\_ENC_{1N} & G\_ENC_{2(N-1)} & ... & G\_ENC_{N1} \end{bmatrix} \begin{bmatrix} C_1 \\ C_2 \\ ... \\ C_N \end{bmatrix}$$

in the formula: $R_1$, $R_2$ ..., $R_i$ ..., $R_N$ respectively correspond to the recovery data of the N types of the source data packets, $G\_ENC_{1i}$ indicates the LT coding matrix having same generation rules as $G\_ENC_1$; $G\_ENC_{i1}$ indicates the LT coding matrix having same generation rules as $G\_ENC_i$; $i$ = 1, 2, ... N.

4. The method for adaptive system code FEC encoding and decoding based on media content of claim 3, **characterized in that** when value of the N is 2, corresponding intermediate codes can be generated for data of different importance as follows:

$$\begin{bmatrix} C_1 \\ C_2 \end{bmatrix} = \begin{bmatrix} A_1{}^{-1} & 0 \\ 0 & A_2{}^{-1} \end{bmatrix} \begin{bmatrix} 0 \\ D_1 \\ 0 \\ D_2 \end{bmatrix}$$

changing structure of the LT coding matrix to obtain $G\_ENC_{11}$, $G\_ENC_{12}$, $G\_ENC_{21}$, $G\_ENC_{12}$ and $G\_ENC_1$ having same generation manner; $G\_ENC_{21}$ and $G\_ENC_2$ having same generation manner; $G\_ENC_{11}$ indicating a LT coding matrix having same generation manner as $G\_ENC_1$; $G\_ENC_{21}$ indicating a LT coding matrix having same generation manner as $G\_ENC_2$; $G\_ENC_{12}$ indicating a LT coding matrix having same generation manner as $G\_ENC_1$;

the obtained recovery data $R_1$ is only related to data with a priority of 1, and the recovery data $R_2$ is related to data with priorities of 1 and 2, then obtaining:

$$\begin{bmatrix} D_1 \\ D_2 \\ R_1 \\ R_2 \end{bmatrix} = \begin{bmatrix} G\_ENC_1 & 0 \\ 0 & G\_ENC_2 \\ G\_ENC_{11} & 0 \\ G\_ENC_{12} & G\_ENC_{21} \end{bmatrix} \begin{bmatrix} C_1 \\ C_2 \end{bmatrix}.$$

5. The method for adaptive system code FEC encoding and decoding based on media content of claim 4, **characterized in that** when value of the N is 2, the receiving the encoded symbols and decoding the encoded symbols, comprises:

in the first stage of decoding, obtaining an intermediate codeword according to a recovery matrix W and received source data packets; specifically:

$$W \begin{bmatrix} C_1 \\ C_2 \end{bmatrix} = \begin{bmatrix} 0 \\ REV\_D_1 \\ 0 \\ REV\_D_2 \\ REV\_R_1 \\ REV\_R_2 \end{bmatrix}$$

$$W = \begin{bmatrix} G\_p_1 & 0 \\ REV\_G\_ENC_1 & 0 \\ 0 & G\_p_2 \\ 0 & REV\_G\_ENC_2 \\ REV\_G\_ENC_{11} & 0 \\ REV\_G\_ENC_{12} & REV\_G\_ENC_{21} \end{bmatrix}$$

in the formula: $REV\_G\_ENC_1$ indicates the LT coding matrix with lines corresponding to lost packets removed from $G\_ENC_1$ according to packet loss condition of received encoded symbols; $REV\_G\_ENC_{11}$ indicates the LT coding matrix after with lines corresponding to lost packets removed from $G\_ENC_{11}$ according to packet loss condition of received encoded symbols; $REV\_G\_ENC_{12}$ indicates the LT coding matrix with lines corresponding to lost packets from $G\_ENC_{12}$ according to packet loss condition of received encoded symbols; $REV\_G\_ENC_2$ indicates the LT coding matrix with lines corresponding to lost packets from $G\_ENC_2$ according to packet loss condition of received encoded symbols; $REV\_G\_ENC_{21}$ indicates the LT coding matrix with lines corresponding to lost packets from $G\_ENC_{21}$ according to packet loss condition of received encoded symbols;

making $\quad REV\_A = \begin{bmatrix} G\_p_1 & 0 \\ REV\_G\_ENC_1 & 0 \\ REV\_G\_ENC_{11} & 0 \\ 0 & G\_p_2 \\ 0 & REV\_G\_ENC_2 \\ REV\_G\_ENC_{12} & REV\_G\_ENC_{21} \end{bmatrix}$ ; and decoding according to a number of received source data packets with a corresponding priority and a total number of received data packets;

when a total number of received encoded symbols is less than a number of encoded symbols generated by the source data, and a number of rows is less than a number of columns in $REV\_A_1 = \begin{bmatrix} G\_p_1 \\ REV\_G\_ENC_1 \\ REV\_G\_ENC_{11} \end{bmatrix}$;

both $C_1$, $C_2$ are unable to be solved;

when the total number of received encoded symbols is less than the number of encoded symbols generated by the source data, and the number of rows is greater than or equal to the number of columns in

$REV\_A_1 = \begin{bmatrix} G\_p_1 \\ REV\_G\_ENC_1 \\ REV\_G\_ENC_{11} \end{bmatrix}$; if the number of rows is greater than or equal to the number of columns in $REV\_A_1 = \begin{bmatrix} G\_p_1 \\ REV\_G\_ENC_1 \\ REV\_G\_ENC_{11} \end{bmatrix}$, then $REV\_A_1$ is invertible, a corresponding inverse matrix is recorded as $REV\_A_1^{-1}$; then it can be obtained: $[C_1] = REV\_A^{-1} \begin{bmatrix} 0 \\ REV\_D_1 \\ REV\_R_1 \end{bmatrix}$ wherein: $C_2$ has no

solution;

in the formula: $REV\_D_1$ indicates received source data with a priority of 1, $REV\_R_1$ indicates received recovery data of the source data with the priority of 1;

when the total number of received encoded symbols is greater than or equal to the number of encoded symbols generated by the source data, and the number of rows is greater than or equal to the number of columns in

$REV\_A_1 = \quad REV\_G\_ENC_1$; if the number of rows is greater than or equal to the number of columns in

$REV\_A_1 = \begin{bmatrix} G\_p_1 \\ REV\_G\_ENC_1 \\ REV\_G\_ENC_{11} \end{bmatrix}$, then $REV\_A_1$ is invertible, a corresponding inverse matrix is recorded as $REV\_A_1^{-1}$; if a number of rows is greater than or equal to a number of columns in

$REV\_A_2 = \begin{bmatrix} G\_p_2 \\ REV\_G\_ENC_2 \\ REV\_G\_ENC_{21} \end{bmatrix}$, then $REV\_A_2$ is invertible, a corresponding inverse matrix is recorded

as $REV\_A_2^{-1}$; if both $REV\_A_1$ and $REV\_A_2$ are invertible, then $REV\_A$ is invertible, a corresponding inverse matrix is recorded as *REV_A*-1, recording $B_{1\_1} = \begin{bmatrix} 0 \\ 0 \\ REV\_G\_ENC_{12} \end{bmatrix}$, then

$$REV\_A^{-1} = \begin{bmatrix} REV\_A_1^{-1} & 0 \\ REV\_A_2^{-1}B_{1\_1}REV\_A_1^{-1} & REV\_A_2^{-1} \end{bmatrix};$$ obtaining:

$$\begin{bmatrix} C_1 \\ C_2 \end{bmatrix} = REV\_A^{-1}\begin{bmatrix} 0 \\ REV\_D_1 \\ REV\_R_1 \\ 0 \\ REV\_D_2 \\ REV\_R_2 \end{bmatrix} = \begin{bmatrix} REV\_A_1^{-1} & 0 \\ REV\_A_2^{-1}B_{1\_1}REV\_A_1^{-1} & REV\_A_2^{-1} \end{bmatrix}\begin{bmatrix} 0 \\ REV\_D_1 \\ REV\_R_1 \\ 0 \\ REV\_D_2 \\ REV\_R_2 \end{bmatrix};$$

if the number of rows is less than the number of columns in $REV\_A_2 = REV\_G\_ENC_2$, then $REV\_A_2$

does not have an inverse matrix, only $[C_1] = REV\_A^{-1}\begin{bmatrix} 0 \\ REV\_D_1 \\ REV\_R_1 \end{bmatrix}$ is obtained;

in the formula: $REV\_D_2$ indicates received source data with a priority of 2, $REV\_R_2$ indicates received recovery data of the source data with priorities of 1 and 2;
when the total number of received encoded symbols is greater than or equal to the number of encoded symbols generated by the source data, and the number of rows is less than the number of columns in

$$REV\_A_1 = \begin{bmatrix} G\_p_1 \\ REV\_G\_ENC_1 \\ REV\_G\_ENC_{11} \end{bmatrix},$$ the number of rows is greater than or equal to the number of columns in $REV\_A_2 = \begin{bmatrix} G\_p_2 \\ REV\_G\_ENC_2 \\ REV\_G\_ENC_{21} \end{bmatrix};$

using Gaussian elimination method to directly solve matrix *REV_A*, that is, solving following linear equations:

$$\begin{bmatrix} G\_p_1 & 0 \\ REV\_G\_ENC_1 & 0 \\ REV\_G\_ENC_{11} & 0 \\ 0 & G\_p_2 \\ 0 & REV\_G\_ENC_2 \\ REV\_G\_ENC_{12} & REV\_G\_ENC_{21} \end{bmatrix}\begin{bmatrix} C_1 \\ C_2 \end{bmatrix} = \begin{bmatrix} 0 \\ REV\_D_1 \\ REV\_R_1 \\ 0 \\ REV\_D_2 \\ REV\_R_2 \end{bmatrix}$$

obtaining $C_1$, $C_2$.

6. The method for adaptive system code FEC encoding and decoding based on media content of claim 3, **characterized in that** due to a loss of a part of the data, a recovery matrix needs to be generated according to received encoded symbols, which is equivalent to erasing matrix rows corresponding to lost encoded symbols to form the corresponding recovery matrix, recorded as *REV_G_ENC*; according to different numbers of received data packets, intermediate codewords are generated for different conditions; specifically, following steps are comprised:

step A1: assuming that data packets with *l* types of priorities are received; then obtaining a following recovery matrix equation:

$$
\begin{bmatrix}
\text{G\_p}_1 & 0 & \dots & 0 \\
REV\_G\_ENC_1 & 0 & \dots & 0 \\
0 & \text{G\_p}_2 & \dots & 0 \\
0 & REV\_G\_ENC_2 & \dots & 0 \\
\dots & \dots & \dots & \dots \\
0 & 0 & \dots & \text{G\_p}_l \\
0 & 0 & \dots & REV\_G\_ENC_l \\
REV\_G\_ENC_{11} & 0 & \dots & 0 \\
REV\_G\_ENC_{12} & REV\_G\_ENC_{21} & \dots & 0 \\
\dots & \dots & \dots & \dots \\
REV\_G\_ENC_{1l} & REV\_G\_ENC_{2(l-1)} & \dots & REV\_G\_ENC_{l1}
\end{bmatrix}
\begin{bmatrix}
C_1 \\
C_2 \\
\dots \\
C_l
\end{bmatrix}
=
\begin{bmatrix}
0 \\
REV\_D_1 \\
0 \\
REV\_D_2 \\
\dots \\
0 \\
REV\_D_l \\
REV\_R_1 \\
REV\_R_2 \\
\dots \\
REV\_R_l
\end{bmatrix}
$$

performing an elementary row transformation on the recovery matrix equation, obtaining:

$$
\begin{bmatrix}
\text{G\_p}_1 & 0 & \dots & 0 \\
REV\_G\_ENC_1 & 0 & \dots & 0 \\
REV\_G\_ENC_{11} & 0 & \dots & 0 \\
0 & \text{G\_p}_2 & \dots & 0 \\
0 & REV\_G\_ENC_2 \dots & \dots & \dots \\
REV\_G\_ENC_{12} & REV\_G\_ENC_{21} & \dots & 0 \\
\dots & \dots & \dots & \dots \\
0 & 0 & \dots & \text{G\_p}_l \\
0 & 0 & \dots & REV\_G\_ENC_l \\
REV\_G\_ENC_{1l} & REV\_G\_ENC_{2(l-1)} & \dots & REV\_G\_ENC_{l1}
\end{bmatrix}
\begin{bmatrix}
C_1 \\
C_2 \\
\dots \\
C_l
\end{bmatrix}
=
\begin{bmatrix}
0 \\
REV\_D_1 \\
REV\_R_1 \\
0 \\
REV\_D_2 \\
REV\_R_2 \\
\dots \\
0 \\
REV\_D_l \\
REV\_R_l
\end{bmatrix}
$$

in the formula: $REV\_G\_ENC_1$ indicates the LT coding matrix with lines corresponding to lost packets removed from $G\_ENC_1$ according to packet loss condition of the received encoded symbols; $REV\_G\_ENC_{11}$ indicates the LT coding matrix with lines corresponding to lost packets removed from $G\_ENC_{11}$ according to packet loss condition of the received encoded symbols; $REV\_G\_ENC_{12}$ indicates the LT coding matrix with lines corresponding to lost packets removed from $G\_ENC_{12}$ according to packet loss condition of the received encoded symbols; $REV\_G\_ENC_2$ indicates the LT coding matrix with lines corresponding to lost packets removed from $G\_ENC_2$ according to packet loss condition of the received encoded symbols; $REV\_G\_ENC_{21}$ indicates the LT coding matrix with lines corresponding to lost packets removed from $G\_ENC_{21}$ according to packet loss condition of the received encoded symbols; $REV\_D_1$ indicates received source data with a priority of 1, $REV\_R_1$ indicates received recovery data of the source data with the priority of 1; $REV\_D_2$ indicates a received source data with a priority of 2, $REV\_R_2$ indicates received recovery data of the data with priorities of 1 and 2; $REV\_G\_ENC_{1l}$ indicates the LT coding matrix with lines corresponding to lost packets removed from $G\_ENC_{1l}$ according to packet loss condition of the received encoded symbols, $REV\_D_l$ indicates received source data with a priority of *l*, $REV\_R_l$ indicates received recovery data of the source data with priorities of 1 to *l*, $C_l$ indicates a generated intermediate code of type *l*;

step A2: making

$$\text{REV\_A} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 \, ... & ... & ... \\ REV\_G\_ENC_{12} & REV\_G\_ENC_{21} & ... & 0 \\ ... & ... & ... & ... \\ 0 & 0 & ... & G\_p_l \\ 0 & 0 & ... & REV\_G\_ENC_l \\ REV\_G\_ENC_{1l} & REV\_G\_ENC_{2(l-1)} & ... & REV\_G\_ENC_{l1} \end{bmatrix},$$

making R($i$) be a number of encoded symbols of level $i$ as received and extended, L($i$) be a symbol length of each level at an encoding end, wherein: $1 \leq i \leq l$;

calculating a rank of a generated matrix of each level:

$$\text{eachRank(i)} = \min(\text{Len}(R(i)), \text{sum}(L(1:i)));$$

in the formula: eachRank(i) indicates a rank of a sub-matrix corresponding to data with a priority of i, wherein a corresponding sub-matrix is $\begin{bmatrix} 0 & G\_p_2 \\ 0 & REV\_G\_ENC_2 \\ REV\_G\_ENC_{12} & REV\_G\_ENC_{21} \end{bmatrix}$ when i=2, Len(R(i)) indicates a length of the number of received encoded symbols with a priority of i, sum(L(1: i)) indicates a number of columns of a sub-matrix with a priority of i, min() indicates a minimum operation;
calculating a rank of an accumulated matrix:

$$\text{cumRank(i)} = \min(\text{cumRank(i} - 1) + \text{eachRank(i)}, \text{sum}(L(1:i))),$$

in the formula: cumRank(i) indicates a sum of ranks of sub-matrices corresponding to a priority of 1 to a priority of i, cumRank(i - 1) indicates a sum of ranks of sub-matrices corresponding to a priority of 1 to a priority of i-1;
wherein cumRank(1) = eachRank(1);
judging cumRank(i) >= $sum(L(1: i))$ in order: if it is true, cumFullRank(i) = 1; otherwise cumFullRank(i) = 0; cumFullRank(i) indicates a full rank of a matrix consisting of sub-matrices corresponding to a priority of 1 to a priority of i;

step A3: according to the number of received encoded symbol of each level, respectively obtaining intermediate codes $C_1$, $C_2$, ... $C_l$ according to conditions, setting a initial value of $i$ to 1;
if cumFullRand(i) == 1 && cumFullRank(1:i) > 0 is satisfied, using RFC 6330 decoding method to solve $C_1 \sim C_i$, wherein: && indicates an AND operation, cumFullRank(1:i) indicates a full rank of the matrix consisting of sub-matrices of priorities from 1 to i; $C_1$ indicates an intermediate codeword corresponding to data with a priority of 1, $C_i$ indicates an intermediate codeword corresponding to data with a priority of $i$;

assuming $REV\_A_{\Delta i} = \begin{bmatrix} G\_p_1 & 0 & ... & 0 \\ REV\_G\_ENC_1 & 0 & ... & 0 \\ REV\_G\_ENC_{11} & 0 & ... & 0 \\ 0 & G\_p_2 & ... & 0 \\ 0 & REV\_G\_ENC_2 ... & ... & ... \\ REV\_G\_ENC_{12} & REV\_G\_ENC_{21} & ... & 0 \\ ... & ... & ... & ... \\ 0 & 0 & ... & G\_p_i \\ 0 & 0 & ... & REV\_G\_ENC_i \\ REV\_G\_ENC_{1i} & REV\_G\_ENC_{2(i-1)} & ... & REV\_G\_ENC_{i1} \end{bmatrix}$,

obtaining:

$$REV\_A_{\Delta i}^{-1} = \begin{bmatrix} A_1^{-1} & 0 & 0 & 0 \\ X_{1\_2} & A_2^{-1} & 0 & 0 \\ ... & ... & ... & 0 \\ X_{1\_i} & X_{2\_(i-1)} & ... & A_i^{-1} \end{bmatrix},$$

wherein:

$X_{1\_2} = A_2^{-1}B_{1\_2}A_1^{-1}$, $X_{a\_b} = A_b^{-1}B_{a\_b}A_a^{-1} + \sum_{k=a+1}^{b-1} A_b^{-1} B_{k\_b}X_{a\_k}$,

in the formula: $REV\_A_{\Delta i}$ indicates a full rank matrix consisting of all sub-matrices until the priority reaches i,

$B_{1\_2}$ indicates sub-matrix $\begin{bmatrix} 0 \\ 0 \\ REV\_G\_ENC_{12} \end{bmatrix}$, $X_{1\_2}$ indicates a sub-matrix after an inverse operation on sub-matrix $B_{1\_2}$, $X_{a\_b}$ indicates a sub-matrix obtained after an inverse operation of sub-matrix $B_{a\_b}$, $B_{a\_b}$ indicates

sub-matrix $\begin{bmatrix} 0 \\ 0 \\ REV\_G\_ENC_{ab} \end{bmatrix}$, the range of a is 1 ~ i, the range of b is 2 ~ i, $A_i^{-1}$ indicates an inverse matrix

of sub-matrix $\begin{bmatrix} G\_p_i \\ REV\_G\_ENC_i \\ REV\_G\_ENC_{i1} \end{bmatrix}$;

making $C_{i\_temp} = REV\_A_i^{-1} \begin{bmatrix} 0 \\ REV\_D_i \\ REV\_R_i \end{bmatrix}$, wherein, $REV\_A_i = \begin{bmatrix} G\_p_i \\ REV\_G\_ENC_i \\ REV\_G\_ENC_{i1} \end{bmatrix}$; $REV\_A_i^{-1}$

is an inverse matrix of $REV\_A_i$, then obtaining:

$$C_1 = C_{1\_temp}$$

$$C_2 = C_{2\_temp} + X_{1\_2} \begin{bmatrix} 0 \\ REV\_D_1 \\ REV\_R_1 \end{bmatrix} = C_{2\_temp} + A_2^{-1}B_{1\_2}C_1$$

$$C_3 = C_{3\_temp} + X_{1\_3}\begin{bmatrix} 0 \\ REV\_D_1 \\ REV\_R_1 \end{bmatrix} + X_{2\_3}\begin{bmatrix} 0 \\ REV\_D_2 \\ REV\_R_2 \end{bmatrix} = C_{2\_temp} + A_3^{-1}B_{1\_3}C_1 + A_3^{-1}B_{2\_3}C_2$$

according to mathematical induction, obtaining:

$$C_i = C_{i\_temp} + \sum_{j=1}^{i-1} X_{j\_i}\begin{bmatrix} 0 \\ REV\_D_j \\ REV\_R_j \end{bmatrix} = C_{i\_temp} + \sum_{j=1}^{i-1} A_i^{-1}B_{j\_i}C_j$$

obtaining $C_1$, $C_2$ ... $C_i$ wherein, $C_{i+1}$ ... $C_l$ are unable to be solved;
if cumFullRand(i) == 1 is satisfied, and cumFullRank(1:i) > 0 is not satisfied, using Gaussian elimination method to solve $C_1 \sim C_i$
assuming

$$REV\_A_{\Delta i} = \begin{bmatrix} G\_p_1 & 0 & \ldots & 0 \\ REV\_G\_ENC_1 & 0 & \ldots & 0 \\ REV\_G\_ENC_{11} & 0 & \ldots & 0 \\ 0 & G\_p_2 & \ldots & 0 \\ 0 & REV\_G\_ENC_2 \ldots & \ldots & \ldots \\ REV\_G\_ENC_{12} & REV\_G\_ENC_{21} & \ldots & 0 \\ \ldots & \ldots & \ldots & \ldots \\ 0 & 0 & \ldots & G\_p_i \\ 0 & 0 & \ldots & REV\_G\_ENC_i \\ REV\_G\_ENC_{1i} & REV\_G\_ENC_{2(i-1)} & \ldots & REV\_G\_ENC_{i1} \end{bmatrix},$$

solving following linear equations by Gaussian elimination method:

$$\begin{bmatrix} G\_p_1 & 0 & \ldots & 0 \\ REV\_G\_ENC_1 & 0 & \ldots & 0 \\ REV\_G\_ENC_{11} & 0 & \ldots & 0 \\ 0 & G\_p_2 & \ldots & 0 \\ 0 & REV\_G\_ENC_2 \ldots & \ldots & \ldots \\ REV\_G\_ENC_{12} & REV\_G\_ENC_{21} & \ldots & 0 \\ \ldots & \ldots & \ldots & \ldots \\ 0 & 0 & \ldots & G\_p_i \\ 0 & 0 & \ldots & REV\_G\_ENC_i \\ REV\_G\_ENC_{1i} & REV\_G\_ENC_{2(i-1)} & \ldots & REV\_G\_ENC_{i1} \end{bmatrix}\begin{bmatrix} C_1 \\ C_2 \\ \ldots \\ C_i \end{bmatrix} = \begin{bmatrix} 0 \\ REV\_D_1 \\ REV\_R_1 \\ 0 \\ REV\_D_2 \\ REV\_R_2 \\ \ldots \\ 0 \\ REV\_D_i \\ REV\_i \end{bmatrix}$$

obtaining $C_1$, $C_2$ ... $C_i$, wherein, $C_{i+1}$ ... $C_l$ are unable to be solved;
for any value of $i$, if cumFullRand(i) == 1 is not satisfied then a corresponding $C_i$ is unable to be solved; if cumFullRank(1:i) > 0 is not satisfied either until i == 1, then $C_1$, $C_2$... $C_l$ are all unable to be solved, the decoding failed;
step A4: decrementing the value of i by 1, returning to perform step A3.

7. The method for adaptive system code FEC encoding and decoding based on media content of claim 1, **characterized in that** it further comprises:

parsing importance information of a header of each sub-packet in the source data packet;
according to the importance information, respectively mapping each sub-packet in the source data packet to a different priority;
rearranging the sub-packets according to the priorities of the sub-packets to get an intermediate data packet;
after converting the intermediate data packet into a plurality of symbols, and performing forward error correction (FEC) encoding on the intermediate data packet that is converted into the plurality of symbols, obtaining a recovery data packet comprising a plurality of symbols;
adding an index field and/or a priority indicating field to the recovery data packet, the index field is used to indicate a sequence of sub-packets in the recovery data packet and/or indicate a sequence of sub-packets, in the recovery data packet, at a priority corresponding to the priority indicating field; further adding an index field and/or a priority indicating field to the intermediate data packet, the index field is used to indicate a sequence of the sub-packets in the intermediate data packet and/or indicate a sequence of the sub-packets, in the intermediate data packet, at a priority corresponding to the priority indicating field;
adding corresponding instruction information to the recovery data packet and the intermediate data packet, or sending corresponding instruction information when sending the recovery data packet and the intermediate data packet, the instruction information is used to indicate the sub-packets of the recovery data packet at each priority, and a number or a proportion of the sub-packets belonging to a corresponding priority in the recovery data packet; the indication information is also used to indicate the sub-packets in the intermediate data packet at each priority, and a number or a proportion of the sub-packets belonging to a corresponding priority in the intermediate data packet;
sending the recovery data packet and the intermediate data packet comprising the instruction information to a terminal side, or sending the recovery data packet, the intermediate data packet, and corresponding instruction information to a terminal side.

8. The method for adaptive system code FEC encoding and decoding based on media content of claim 7, **characterized in that** the parsing importance information of a header of each sub-packet in the source data packet, comprises:
   reading a priority field in the header of each sub-packet, determining a priority of a corresponding sub-packet according to information in the priority field.

9. The method for adaptive system code FEC encoding and decoding based on media content of claim 8, **characterized in that** the according to the importance information, respectively mapping each sub-packet in the source data packet to a different priority, comprises:

   determining a number of priorities actually adopted by the source data packet, and a mapping relationship to the priority field at each priority;
   according to the mapping relationship, mapping the sub-packet to a corresponding preset priority.

10. The method for adaptive system code FEC encoding and decoding based on media content of claim 7, **characterized in that** the after converting the intermediate data packet into a plurality of symbols, and performing forward error correction (FEC) encoding on the intermediate data packet that is converted into the plurality of symbols, obtaining a recovery data packet comprising a plurality of symbols, comprises:

   performing FEC encoding on the intermediate data packet, using an adaptive FEC encoding method of a RaptorQ system code, to obtain a following intermediate codeword:

$$\begin{bmatrix} C_1 \\ C_2 \\ \cdots \\ C_N \end{bmatrix} = \begin{bmatrix} A_1^{-1} & 0 & \cdots & 0 \\ 0 & A_2^{-1} & \cdots & 0 \\ \cdots & \cdots & \cdots & \cdots \\ \cdots & \cdots & \cdots & A_N^{-1} \end{bmatrix} \begin{bmatrix} 0 \\ D_1 \\ 0 \\ D_2 \\ \cdots \\ 0 \\ D_N \end{bmatrix}$$

in the formula: $A_i$ indicates a coding matrix corresponding to a source data packet of type $i$, $C_1$, $C_2$, ..., $C_i$ ..., $C_N$ respectively correspond to an intermediate code of the N types of the source data packets, $D_1$, $D_2$, ..., $D_i$ ..., $D_N$

respectively correspond to data of the N types of the source data packets, superscript -1 is an inverse matrix operator;

according to the intermediate codeword, obtaining the recovery data packet, and adding a FEC payload ID to the recovery data packet, wherein, the recovery data in the recovery data packet is as follows:

$$
\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\ (N-1)}} & ... & G_{ENC_{N1}} \end{bmatrix} \begin{bmatrix} C_1 \\ C_2 \\ ... \\ C_N \end{bmatrix}
$$

in the formula: $R_1$, $R_2$, ..., $R_i$ ..., $R_N$ respectively correspond to recovery data of 1~N source data packets, $G\_ENC_i$ indicates a LT coding matrix corresponding to an *i-th* source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

11. A method for adaptive system code FEC encoding and decoding based on media content, **characterized in that** it comprises:

   receiving a recovery data packet and an intermediate data packet sent by a server, or receiving a recovery data packet, an intermediate data and corresponding instruction information;
   parsing out an index field comprised in the recovery data packet and the intermediate data packet, and generating a coding matrix according to the index field, wherein, the index field is used to indicate a sequence of sub-packets in the recovery data packet, and indicate sub-packets in the intermediate data packet at each priority; or directly obtaining index information via priority indicating fields of the recovery data packet and the intermediate data packet, and generating a coding matrix according to the index information, wherein, the index information is used to indicate a sequence of sub-packets in the recovery data packet and indicate sub-packets in the intermediate data packet at each priority;
   performing forward error correction (FEC) decoding on the coding matrix to recover the intermediate data packet;
   parsing information in a header of the intermediate data packet, rearranging a sequence of the sub-packets in the intermediate data packet, and recovering a source data packet.

12. The method for adaptive system code FEC encoding and decoding based on media content of claim 11, **characterized in that** the parsing out an index field comprised in the recovery data packet and the intermediate data packet, comprises:
   obtaining an index field of a corresponding row of a coding matrix corresponding to the source data by a following formula:

$$
index = FEC\ payload\ ID -
$$

$$
number\ of\ packets\ of\ all\ priorities\ before\ this\ packet
$$

   in the formula: the index indicates a corresponding row index of the coding matrix corresponding to the source data, the FEC payload ID indicates index information of the header of the data packet, the number of packets of all priorities before this packet indicates a total number of data packets of all priorities before the packet.

13. The method for adaptive system code FEC encoding and decoding based on media content of claim 11, **characterized in that** the performing forward error correction (FEC) decoding on the coding matrix to recover the intermediate data packet, comprises:

performing an elementary row transformation on the coding matrix, and sorting symbols in a received corresponding recovery data packet, determining belonged priorities and transformed positions of the symbols according to a value of the index information FEC_payload_ID of the header of the recovery data packet and a number of the symbols with a corresponding priority; or

according to a priority field in the header of the recovery packet and the index information with a priority corresponding to the priority field, directly determining belonged priorities and transformed positions of the symbols; adjusting a sequence of the symbols in the recovery data packet, and obtaining the recovered intermediate data packet comprising a plurality of symbols after a decoding by a Gaussian elimination decoder and a RFC6330 decoder;

converting the intermediate data packet comprising the plurality of symbols into the intermediate packet.

14. A device for adaptive system code FEC encoding and decoding based on media content, **characterized in that** it comprises:

a parsing module, configured to parse importance information of a header of each sub-packet in a source data packet;

a mapping module, configured to respectively map each sub-packet in the source data packet to a different preset priority according to the importance information;

a sorting module, configured to rearrange the sub-packets according to the preset priority to obtain an intermediate data packet;

an encoding module, configured to convert the intermediate data packet into a plurality of symbols, and obtain a recovery data packet, comprising the plurality of symbols, after performing forward error correction (FEC) encoding on the intermediate data packet that is converted to a plurality of symbols;

an indexing module, configured to add an index field and/or a priority indicating field to the recovery data packet, the index field is used to indicate a sequence of sub-packets in the recovery data packet and/or indicate a sequence of sub-packets in the recovery data packet with a priority corresponding to the priority indicating field; further add an index field and/or a priority indicating field to the intermediate data packet, the index field is used to indicate a sequence of sub-packets in the intermediate data packet and/or indicate a sequence of sub-packets in the intermediate data packet with a priority corresponding to the priority indicating field;

an instruction information generating module, configured to add corresponding instruction information to the recovery data packet and the intermediate data packet, or send corresponding instruction information when sending the recovery data packet and the intermediate data packet; wherein, the instruction information is used to indicate the sub-packets of the recovery data packet at each priority, and a number or a proportion of the sub-packets belonging to a corresponding priority in the recovery data packet; the instruction information is further used to indicate the sub-packets of the intermediate data packet at each priority, and a number or a proportion of the sub-packets belonging to a corresponding priority in the intermediate data packet;

a sending module, configured to send the recovery data packet, the intermediate data packet, and corresponding signaling information to a terminal side, or send the recovery data packet, the intermediate data packet and corresponding instruction information to a terminal side.

15. The device for adaptive system code FEC encoding and decoding based on media content of claim 14, **characterized in that** the encoding module is specifically configured to:

perform FEC encoding on the intermediate data packet, using an adaptive FEC encoding method of a RaptorQ system code, to obtain a following intermediate codeword:

$$\begin{bmatrix} C_1 \\ C_2 \\ ... \\ C_N \end{bmatrix} = \begin{bmatrix} A_1^{-1} & 0 & ... & 0 \\ 0 & A_2^{-1} & ... & 0 \\ ... & ... & ... & ... \\ ... & ... & ... & A_N^{-1} \end{bmatrix} \begin{bmatrix} 0 \\ D_1 \\ 0 \\ D_2 \\ ... \\ 0 \\ D_N \end{bmatrix}$$

in the formula: $A_i$ indicates a coding matrix corresponding to a source data packet of type $i$, $C_1, C_2, ..., C_i ..., C_N$

respectively correspond to an intermediate code of the N types of the source data packets, $D_1, D_2, ..., D_i ..., D_N$ respectively correspond to data of the N types of the source data packets, superscript -1 is an inverse matrix operator;

according to the intermediate codeword, obtain the recovery data packet, and adding a FEC payload ID to the recovery data packet, wherein, the recovery data in the recovery data packet is as follows:

$$\begin{bmatrix} D_1 \\ D_2 \\ ... \\ D_N \\ R_1 \\ R_2 \\ ... \\ R_N \end{bmatrix} = \begin{bmatrix} G_{ENC_1} & 0 & ... & 0 \\ 0 & G_{ENC_2} & ... & 0 \\ ... & ... & ... & ... \\ 0 & ... & ... & G_{ENC_N} \\ G_{ENC_{11}} & 0 & ... & 0 \\ G_{ENC_{12}} & G_{ENC_{21}} & ... & 0 \\ ... & ... & ... & ... \\ G_{ENC_{1N}} & G_{ENC_{2\,(N-1)}} & ... & G_{ENC_{N1}} \end{bmatrix} \begin{bmatrix} C_1 \\ C_2 \\ ... \\ C_N \end{bmatrix}$$

in the formula: $R_1, R_2, ..., R_i ..., R_N$ respectively correspond to recovery data of 1~N source data packets, $G\_ENC_i$ indicates a LT coding matrix corresponding to an *i-th* source data packet, $G\_ENC_{1i}$ indicates a LT coding matrix having same generation rules as $G\_ENC_1$; $G\_ENC_{i1}$ indicates a LT coding matrix having same generation rules as $G\_ENC_i$; $i$ = 1, 2, ... N.

16. A device for adaptive system code FEC encoding and decoding based on media content, **characterized in that** it comprises:

a receiving module, configured to receive a recovery data packet and an intermediate data packet sent by a server, or receive a recovery data packet, an intermediate data and corresponding instruction information;

a coding matrix generating module, configured to parse out an index field comprised in the recovery data packet and the intermediate data packet, and generate a coding matrix according to the index field, wherein, the index field is used to indicate a sequence of sub-packets in the recovery data packet and indicate sub-packets of the intermediate data packet at each priority; or

directly obtain index information via the priority indicating field of the recovery data packet and the intermediate data packet, and generate a coding matrix according to the index information, wherein, the index information is used to indicate a sequence of the sub-packets in the recovery data packet and indicate sub-packets of the intermediate packet at each priority;

a decoding module, configured to perform forward error correction (FEC) decoding on the coding matrix to recover the intermediate data packet;

a recovering module, configured to parse information in the header of the intermediate data packet, rearrange a sequence of the sub-packets in the intermediate data packet, and recover the source data packet.

17. The device for adaptive system code FEC encoding and decoding based on media content of claim 16, **characterized in that** the coding matrix generating module is specifically configured to:

obtain an index field of a corresponding row of a coding matrix corresponding to the source data by a following formula:

$$index = FEC\ payload\ ID -$$

$$number\ of\ packets\ of\ all\ priorities\ before\ this\ packet$$

in the formula: the index indicates a corresponding row index of the coding matrix corresponding to the source data, the FEC payload ID indicates index information of the header of the data packet, the number of packets of all priorities before this packet indicates a total number of packets of all priorities before the packet.

18. The device for adaptive system code FEC encoding and decoding based on media content of claim 16, **characterized in that** the decoding module is specifically configured to:

perform an elementary row transformation on the coding matrix, and sort the symbols in a received corresponding recovery data packet, determining belonged priorities and transformed positions of the symbols according to a value of the index information FEC_payload_ID of the header of the recovery data packet and a number of the symbols with a corresponding priority; or

according to a priority field in the header of the recovery packet and the index information with a priority corresponding to the priority field, directly determining a belonged priority and a transformed position of the symbols; adjusting a sequence of the symbols in the recovery data packet, and obtaining the recovered intermediate data packet comprising a plurality of symbols after a decoding by a Gaussian elimination decoder and a RFC6330 decoder;

converting the intermediate data packet comprising the plurality of symbols into the intermediate packet.

**19.** A system for adaptive system code FEC encoding and decoding based on media content, **characterized in that** it comprises a server and at least one terminal, wherein, the server is configured to perform the method for adaptive system code FEC encoding and decoding based on media content according to any one of claims 7-10, the terminal is configured to perform the method for adaptive system code FEC encoding and decoding based on media content according to any one of claims 11-13.

**20.** A computer readable storage medium storing a computer program, **characterized in that** when the computer program is executed by a processor, the steps of the image-based stripe cloth detection positioning and cutting method according to any one of claims 7 to 13 are performed.

| Source data packet block | | | | |
|---|---|---|---|---|

| 1st source data packet block | 2nd source data packet block | ... | Mth source data packet block |
|---|---|---|---|

| 1st source symbol block | 2nd source symbol block | ... | Mth source symbol block |
|---|---|---|---|

| FEC 1 encoder | FEC 2 encoder |
|---|---|

| 1st source symbol block | 1st P1 | 2nd source symbol block | 2nd P1 | ... | Mth source symbol block | Mth P1 | P2 |
|---|---|---|---|---|---|---|---|

## FIG.1

| Image group #1 | | Image group #2 |
|---|---|---|

| I | B | B | P | B | B | P | B | B | P | B | B | P | B | B | I | B | B | ... |
|---|---|---|---|---|---|---|---|---|---|---|---|---|---|---|---|---|---|---|

## FIG.2

FIG.3

FIG.4

FIG.5

| G_LDPC,1 | I_S | G_LDPC,2 |
|---|---|---|

G_p — | G_HDPC | I_H |

| G_ENC |

FIG.6

| G_p | 0 |
| G_ENC1 | |
| 0 | G_p |
| | G_ENC2 |

FIG.7

| G_ENC1 | 0 |
|---|---|
| 0 | G_ENC2 |
| G_ENC1' | 0 |
| G_ENC1" | G_ENC2' |

FIG.8

FIG.9

Start decoding

Receiving data symbols

Assuming R(i) (1≤i≤ l) is received and extended symbol number of level i, L(i) is the length of symbol at each priority of the encoding end;
For I = 1:l
calculating the rank of generated matrix at each level eachRank(i) = min(Len(R(i)), sum(L(1:i)));
then calculating the rank of accumulated cumRank(i) = min(cumRank(i-1) + eachRank(i), sum(L (1: i))), wherein cumRank(1) = eachRank(1)
end

cumFullRank(i) = 1

Yes

cumRank(i) >= sum(L(1:i))

No

cumFullRank(i) = 0

cumFullRank(i)
(1≤i≤l)

For i=l:-1:1
cumFullRand(i) == 1 ?

Yes → cumFullRank(1:i) > 0 → Yes

No

No

The intermediate code C(i) cannot be solved, setting the value to 0.
If i==1, none of the intermediate codes can be solved.

Using Gaussian elimination decode to decode and solve C(1) ~ C(i)

Using RFC 6330 decode to decode and solve C(1) ~ C(i)

Performing XOR operation to the intermediate symbols according to the generated matrix to generate recovery symbols

Stop decoding

FIG.10

**FEC encoding**

**First stage** — Redesign the FEC coding matrix A According to the priority of the source data

**Second stage** — Design a LT coding matrix according to the generated intermediate codewords to increase the protection strength for the intermediate codewords of important data

Mapping relationship between the priority and the importance of data packets

Source Data packet

Instruction information: Priority, Index, Number of data packets

Add new index of data packet to generate singnaling information

Source data packet

Recovery data packet

**FEC decoding**

**First stage** — According to the received source data and recovery data, generate a corresponding coding matrix, and according to the condition of data loss, delete corresponding rows in the coding matrix to generate intermediate codewords

**Second stage** — Recover the source data according to the obtained intermediate codewords

Instruction information: Priority, Index, Number of data packets

Parse the index of data packet and the signaling information

Recover the origin data, the source data can be obtained after the reordering according to the origin index

Source Data packet

FIG.11

FIG.12

Priorities from high to low

Priority 1 Priority 2 Priority 3 Priority 4

FIG.13

FIG.14

FIG.15

The index of source data packet forward error correction code is 1
The index in the corresponding coding matrix is 1

The index of source data packet forward error correction code is 102
The index in the corresponding coding matrix is 2

FIG.16

FIG.17

Priorities from high to low →

| 1 | 2 | 3 | ⋯ | K1 | 1 | 2 | ⋯ | K2 | 1 | ⋯ | K3 | 1 | ⋯ | K4 |

Recover the sort sequence of data packets in the data steam
according to packet_sequence_number

| 1 | 2 | 1 | 1 | 1 | 3 | 2 | ⋯ | ⋯ | ⋯ | ⋯ | K2 | K3 | K4 | K1 |

Origin sequence →

## FIG.18

| 1 | 2 | 3 | ⋯ | K1 | 1 | 2 | ⋯ | K2 |

| 1 | ⋯ | K3 | 1 | ⋯ | K4 |

Parsing of source data packet header →

Source data packet

The priority of the data packet and number of source packets at the priority
+
Index of source data forward error correction code

| 1 | ⋯ | P1 | 1 | ⋯ | P2 | 1 | ⋯ | P3 |

| 1 | ⋯ | P4 |

Parsing of recovery data packet header →

Recovery data packet

The priority of the data packet and number of recovery packets at the priority
+
Index of recovery data forward error correction code

## FIG.19

## INTERNATIONAL SEARCH REPORT

| International application No. |
| --- |
| **PCT/CN2018/095051** |

| A. | CLASSIFICATION OF SUBJECT MATTER |
| --- | --- |
| | H04L 1/00(2006.01)i |

According to International Patent Classification (IPC) or to both national classification and IPC

| B. | FIELDS SEARCHED |
| --- | --- |

Minimum documentation searched (classification system followed by classification symbols)

H04L; H04N

Documentation searched other than minimum documentation to the extent that such documents are included in the fields searched

Electronic data base consulted during the international search (name of data base and, where practicable, search terms used)

CNPAT, CNKI, EPODOC, WPI, 3GPP: 前向纠错编码, 编码, 译码, 解码, 自适应, 优先, 中间码, 媒体, 非等错保护, 不等差错保护, FEC, coding, encode, decode, adaptive, priority, intermediat code, media, UEP, unequal error protection

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 106603192 A (SHANGHAI JIAO TONG UNIVERSITY) 26 April 2017 (2017-04-26) description, paragraphs 41-72 | 1-20 |
| A | CN 103248897 A (HARBIN INSTITUTE OF TECHNOLOGY SHENZHEN GRADUATE SCHOOL) 14 August 2013 (2013-08-14) entire document | 1-20 |
| A | EP 1198100 A2 (AGERE SYSTEMS GUARDIAN CORPORATION) 17 April 2002 (2002-04-17) entire document | 1-20 |
| A | EP 2091205 A1 (NTT DOCOMO, INC.) 19 August 2009 (2009-08-19) entire document | 1-20 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **30 August 2018** | **27 September 2018** |

| Name and mailing address of the ISA/CN | Authorized officer |
| --- | --- |
| **State Intellectual Property Office of the P. R. China** **No. 6, Xitucheng Road, Jimenqiao Haidian District, Beijing** **100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2018/095051**

| Patent document cited in search report | | | Publication date (day/month/year) | Patent family member(s) | | | Publication date (day/month/year) |
|---|---|---|---|---|---|---|---|
| CN | 106603192 | A | 26 April 2017 | CN | 105827361 | A | 03 August 2016 |
| | | | | KR | 20170102524 | A | 11 September 2017 |
| | | | | WO | 2016110275 | A1 | 14 July 2016 |
| | | | | CA | 2998900 | A1 | 14 July 2016 |
| | | | | CN | 105991226 | A | 05 October 2016 |
| | | | | CN | 106603193 | A | 26 April 2017 |
| | | | | JP | 2018505597 | A | 22 February 2018 |
| | | | | US | 2018069654 | A1 | 08 March 2018 |
| CN | 103248897 | A | 14 August 2013 | None | | | |
| EP | 1198100 | A2 | 17 April 2002 | JP | 2002185429 | A | 28 June 2002 |
| | | | | US | 6684367 | B1 | 27 January 2004 |
| EP | 2091205 | A1 | 19 August 2009 | None | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201710973473

- CN 201710561850